# EUROPEAN PATENT APPLICATION

(11) **EP 4 033 617 A1**
(43) Date of publication of application: **27.07.2022**
(21) Application number: 20893262.4
(22) Date of filing: 19.11.2020
(51) Int. Cl.: H01S 3/042, H01S 3/08, H01S 3/113, H01S 5/022

(54) **LASER ELEMENT, METHOD FOR MANUFACTURING LASER ELEMENT, LASER DEVICE, AND LASER AMPLIFICATION ELEMENT**

(30) Priority: 28.11.2019 JP 2019215087
(71) Applicant: Sony Group Corporation, Tokyo 108-0075 (JP)
(72) Inventor: KAMATA, Masanao, Tokyo 108-0075 (JP)
(74) Representative: D Young & Co LLP
(86) International application number: PCT/JP2020/043292
(87) International publication number: WO 2021/106757

(57) **Abstract**

[Object] To provide a compact and high-performance laser device and a laser apparatus.

[Solving Means] A laser device according to the present disclosure includes an excitation light source having a first reflective layer with respect to a first wavelength; a laser medium having a second reflective layer with respect to a second wavelength on a first surface facing to the excitation light source and a third reflective layer with respect to the first wavelength on a second surface opposite to the first surface; and a saturable absorber having a fourth reflective layer with respect to the second wavelength on a third surface opposite to the laser medium.

## Description

### Technical Field

The present disclosure relates to a laser device, a method of manufacturing the laser device, a laser apparatus, and a laser amplifying device.

### Background Art

Laser technology is applied in a plurality of fields such as microfabrication, medical equipment or ranging. In particular, the technology of short pulse laser is expected to be applied to a high precision processing technology or a high efficiency wavelength conversion technology. A solid-state laser can be used to obtain a peak power in excess of MW.

### Citation List

### Patent Literature

Patent Literature 1: Japanese Patent Application Laid-open No. 2002-151588

### Disclosure of Invention

### Technical Problem

However, in order to use a solid-state laser, it is necessary to handle an apparatus including many parts which are difficult to adjust. Complexity and cost of the apparatus became a problem in popularization of the solid-state laser.

In view of the above-described problem, the present disclosure provides a compact and high-performance laser device, a method of manufacturing the laser device, a laser apparatus, and a laser amplifying device.

### Solution to Problem

A laser device according to an aspect of the present disclosure includes an excitation light source having a first reflective layer with respect to a first wavelength; a laser medium having a second reflective layer with respect to a second wavelength on a first surface facing to the excitation light source and a third reflective layer with respect to the first wavelength on a second surface opposite to the first surface; and a saturable absorber having a fourth reflective layer with respect to the second wavelength on a third surface opposite to the laser medium.

The first wavelength may be a wavelength of the excitation light generated by the excitation light source, and at least a part of a fourth surface facing to the laser medium of the excitation light source may be an exit surface of the excitation light.

The excitation light source may include a fifth reflective layer with respect to the first wavelength on the fourth surface, and the fifth reflective layer may transmit a part of the first wavelength.

The excitation light source may be a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer.

Transmittance of the fifth reflective layer with respect to the first wavelength may be higher than that of the first reflective layer.

Reflectance of the first reflective layer with respect to the first wavelength may be higher than that of the fifth reflective layer.

The third reflective layer may transmit a part of the first wavelength.

The fourth reflective layer may transmit a part of the second wavelength.

The second wavelength may be an oscillation wavelength of the laser medium.

A first anti-reflective film with respect to the first wavelength may be provided between the excitation light source and the laser medium.

A second anti-reflective film with respect to the second wavelength may be provided between the laser medium and the saturable absorber.

It may further include one or more radiator plates arranged on at least one of between the excitation light source and the laser medium, between the laser medium and the saturable absorber, or on the third surface of the saturable absorber.

It may further include a wavelength conversion material arranged between the second reflective layer and the fourth reflective layer.

The wavelength conversion material may include a sixth reflective layer with respect to a wavelength after conversion by the wavelength conversion material on the fifth surface facing to the excitation light source.

The laser medium may be a laser medium of a four-level system or a three-level system.

A laser device according to an aspect of the present disclosure may include an excitation light source having a first reflective layer with respect to a first wavelength and a second reflective layer with respect to a second wavelength, which are coplanar; a laser medium having a third reflective layer with respect to the first wavelength on a second surface opposite to the excitation light source; and a saturable absorber having a fourth reflective layer with respect to the second wavelength on a third surface opposite to the laser medium.

A method of manufacturing a laser device according to an aspect of the present disclosure may include forming a laminated structure in which a plurality of materials are stacked on a semiconductor substrate and then dicing the laminated structure to manufacture a plurality of laser devices, each laser device including an excitation light source having a first reflective layer with respect to a first wavelength and a second reflective layer with respect to a second wavelength, a laser medium having a second reflective layer with respect to a second wavelength on a first surface facing to the excitation light source and a third reflective layer with respect to the first wavelength on a second surface opposite to the first surface, and a saturable absorber having a fourth reflective layer with respect to the second wavelength on a third surface opposite to the laser medium.

A laser apparatus according to one aspect of the present disclosure may include a plurality of any of the laser devices described above.

The plurality of laser devices may be arranged in a one-dimensional array or a two-dimensional array.

It may further include a drive circuit configured to supply an electrical signal for driving to at least one of the laser devices.

A laser amplifying device according to an aspect of the present disclosure may include an excitation light source having a first reflective layer with respect to a first wavelength; and
an amplifying medium having a second reflective layer with respect to a second wavelength on a first surface facing to the excitation light source and having a third reflective layer with respect to the first wavelength and the second wavelength on a second surface opposite to the first surface.

The excitation light source may include a third surface facing to the amplifying medium,
the first wavelength may be a wavelength of the excitation light generated by the excitation light source, and
at least a part of the third surface may be an emission surface of the excitation light.

The excitation light source may include a fourth reflective layer with respect to the first wavelength on the third surface, and
the fourth reflective layer may transmit a part of the first wavelength.

The excitation light source may be a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer.

The excitation light source may have an active layer of a surface emitting semiconductor laser having a plurality of light emitting points arranged on one surface of the excitation light source, a first multilayer film reflecting mirror, and a second multilayer film reflecting mirror installed through the amplifying medium.

By current injection from outside to the active layer, laser oscillation may occur at a wavelength determined by a band gap of the active layer between first and second multilayer reflecting mirrors, the excitation light generated by the laser oscillation may be pumped by the amplifying medium, and laser light passing through the amplifying medium from the excitation light source may be uniformly amplified.

Pulse laser light may be coupled to the amplifying medium from outside to amplify the output.

### Brief Description of Drawings

[Fig. 1] Fig. 1 shows an example of a laser apparatus in which an optical axis of excitation light and an optical axis of laser light form an angle.
[Fig. 2] Fig. 2 shows an example of a configuration of a laser apparatus when viewed from a direction of the optical axis of the laser light.
[Fig. 3] Fig. 3 is a cross-sectional diagram schematically showing an example of a laser apparatus according to an embodiment of the present disclosure.
[Fig. 4] Fig. 4 is an exploded diagram showing an example of the laser apparatus according to the present disclosure.
[Fig. 5] Fig. 5 is a cross-sectional diagram showing an example of a method of manufacturing a semiconductor laser.
[Fig. 6] Fig. 6 is a cross-sectional diagram showing the example of the method of manufacturing the semiconductor laser followed by Fig. 5.
[Fig. 7] Fig. 7 is a cross-sectional diagram showing the example of the method of manufacturing the semiconductor laser followed by Fig. 6.
[Fig. 8] Fig. 8 is a cross-sectional diagram showing the example of the method of manufacturing the semiconductor laser followed by Fig. 7.
[Fig. 9] Fig. 9 is a cross-sectional diagram showing the example of the method of manufacturing the semiconductor laser followed by Fig. 8.
[Fig. 10] Fig. 10 is a plan diagram showing a configuration example of an electrode.
[Fig. 11] Fig. 11 is a cross-sectional diagram showing the example of the method of manufacturing the semiconductor laser followed by Fig. 9.
[Fig. 12] Fig. 12 is a diagram showing an example in which a plurality of laser devices dice a plate structure integrally formed.
[Fig. 13] Fig. 13 shows an example of a multi-beam laser apparatus.
[Fig. 14] Fig. 14 shows an example of a laser apparatus according to Modification 1.
[Fig. 15] Fig. 15 shows an example of a laser apparatus according to Modification 2.
[Fig. 16] Fig. 16 is an exploded diagram showing an example of a laser device according to Modification 3.
[Fig. 17] Fig. 17 is an exploded diagram showing an example of a laser device according to Modification 4.
[Fig. 18] Fig. 18 is a cross-sectional diagram showing an example of a laser device according to Modification 5.
[Fig. 19] Fig. 19 is a cross-sectional diagram showing an example of a laser device according to Modification 6.
[Fig. 20] Fig. 20 is a cross-sectional diagram showing an example of a laser device according to Modification 7.
[Fig. 21A] Fig. 21A is a top diagram of a laser amplifying device according to a present embodiment.
[Fig. 21B] Fig. 21B is a cross-sectional diagram of the laser amplifying device according to the present embodiment.
[Fig. 21C] Fig. 21C is a cross-sectional diagram of the laser amplifying device having regions not excited among excitation regions.

### Mode(s) for Carrying Out the Invention

Preferable embodiments of the present disclosure will be described in detail with reference to the accompanying drawings. Note that, in the specification and the drawings, components having substantially the same functional configuration are denoted by the same reference numeral to omit a repetitive description.

Before describing a laser device and a laser apparatus according to the present disclosure, examples of common solid-state laser technologies will be described.

### (First Embodiment)

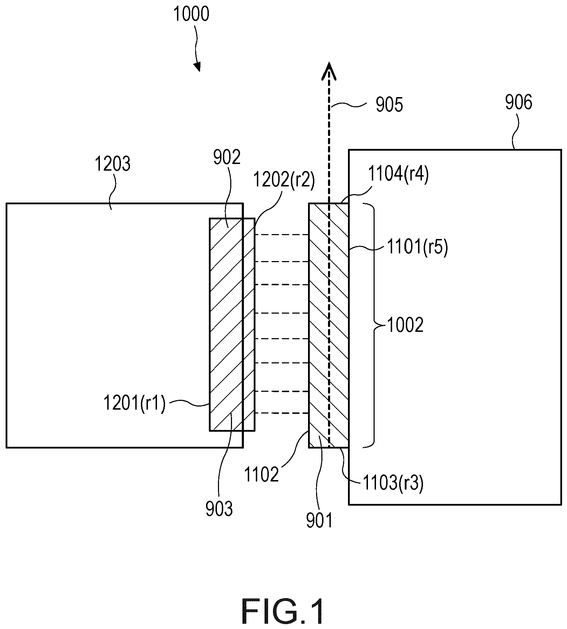

Fig. 1 shows an example of a laser apparatus in which an optical axis of excitation light and an optical axis of laser light form an angle. Fig. 1 shows a cross-sectional diagram of a laser apparatus 1000 cut in a plane including the optical axis of the excitation light and the optical axis of the laser light. The laser apparatus 1000 includes a solid-state laser device 901, a semiconductor laser array 902, a heat sink 906, and a heat sink 1203. The laser apparatus 1000 is a solid-state laser apparatus using a solid-state material as a laser medium.

The semiconductor laser array 902 includes a plurality of light emitting portions arranged in a straight line. Each of the light emitting portions has, for example, an active layer of InGaAs (indium gallium arsenide). However, the active layer of the semiconductor laser array 902 may be another type of semiconductor. The semiconductor laser array 902 generates excitation light in the laser apparatus 1000. That is, the semiconductor laser array 902 laser-oscillates at a center wavelength 940 nm coincident with an absorption band of the solid-state laser device 901. The semiconductor laser array 902 is fixed to the heat sink 1203 via a submount. The heat sink 1203 cools the semiconductor laser array 902. As the heat sink 1203, for example, it is possible to use a water-cooled type heat sink. However, a cooling method of the heat sink 1203 is not limited. In addition, the heat sink 1203 includes a positive electrode (p-electrode) of the semiconductor laser array 902.

On a surface 1201 of the semiconductor laser array 902 opposite to the solid-state laser device 901, a reflective layer r1 for an electromagnetic wave having a wavelength of 940 nm is formed. Furthermore, on a surface 1202 of the semiconductor laser array 902 facing to the solid-state laser device 901, a reflective layer r2 with respect to the electromagnetic wave having the wavelength of 940 nm is formed. Reflectance of the reflective layer r1 with respect to the electromagnetic wave having the wavelength of 940 nm is higher than that of the reflective layer r2.

The solid-state laser device 901 is, for example, a laser medium of a three-level system. For example, YAG (yttrium aluminum garnet) crystal doped with Yb (yttrium) can be used as a three-level system laser medium. The oscillation wavelength of the solid-state laser device 901 is 1030 nm. The solid-state laser device 901 is fixed to the heat sink 906. For example, solder may be used to fix the solid-state laser device 901 to the heat sink 906. As the heat sink 906, for example, it is possible to use the water-cooled type heat sink. However, a heat sink of any cooling type may be used.

On a surface 1103 perpendicular to the optical axis of the solid-state laser device 901, a reflective layer r3 with respect to an electromagnetic wave having a wavelength of 1030 nm is formed. Furthermore, on other surface 1104 perpendicular to the optical axis of the solid-state laser device 901, a reflective layer r4 with respect to the electromagnetic wave having the wavelength of 1030 nm is formed. Reflectance of the reflective layer r3 with respect to electromagnetic wave having the wavelength of 1030 nm is higher than that of the reflective layer r4. Furthermore, on a surface 1101 of the solid-state laser device 901 opposite to the semiconductor laser array 902, a reflective layer r5 with respect to the electromagnetic wave having the wavelength of 940 nm is formed. Furthermore, on a surface 1102 of the solid-state laser device 901 facing to the semiconductor laser array 902, a reflective layer r6 with respect to the electromagnetic wave having the wavelength of 940 nm is formed. Reflectance of the reflective layer r5 with respect to the electromagnetic wave having the wavelength of 940 nm is higher than that of the reflective layer r6.

In Fig. 1, between the surface 1201 and the surface 1101, excitation light 903 emitted from the semiconductor laser array 902 is shown by broken lines. Furthermore, laser light 905 emitted from the solid-state laser device 901 is indicated by a dotted arrow. In the laser apparatus 1000 of Fig. 1, the optical axis of the excitation light 903 is perpendicular to the optical axis of the laser light 905.

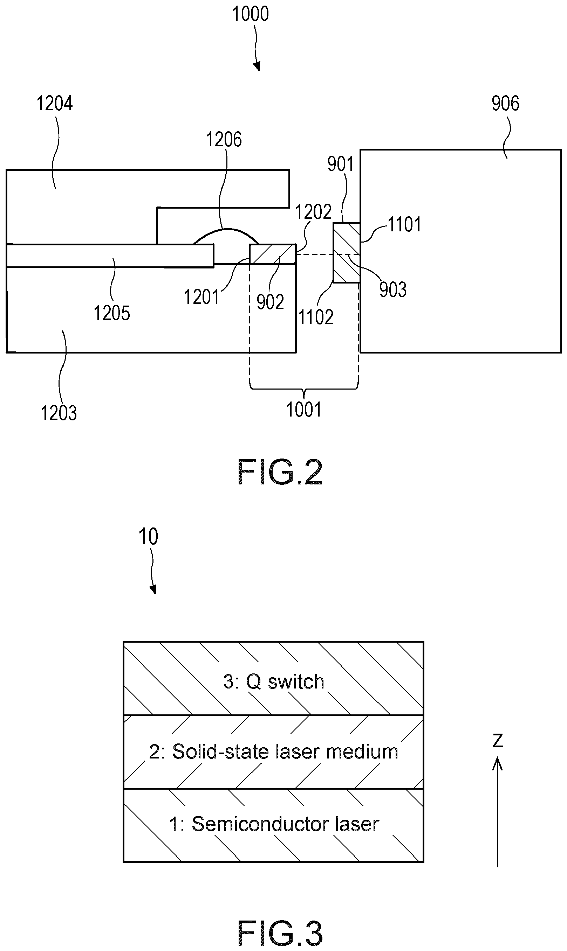

Fig. 2 shows a configuration of the laser apparatus 1000 when viewed from a direction of the optical axis of the laser light 905. In Fig. 2, on the heat sink (positive electrode) 1203, the semiconductor laser array 902 and an insulating plate 1205 are arranged. Furthermore, on the insulating plate 1205, a negative electrode (n-electrode) 1204 is arranged. On an upper surface of the insulating plate 1205 (heat sink 1204 side) and a lower surface of the insulating plate 1205 (heat sink 1203 side), conductive films are formed, respectively. The conductive film is, for example, a metal film. However, the conductive film may be formed of other materials. The negative electrode of the semiconductor laser array 902 is connected to the conductive film on the upper surface of the insulating plate 1205 via wiring 1206. The conductive film on the upper surface of the insulating plate 1205 is in contact with the negative electrode 1204. The negative electrode 1204 and a negative electrode of the semiconductor laser array 902 are electrically conducted. Therefore, the semiconductor laser array 902 is capable of receiving power from the negative electrode 1204. Also, the positive electrode of the semiconductor laser array 902 and the heat sink (positive electrode) 1203 are electrically conducted.

Incidentally, the semiconductor laser array 902, the heat sink (positive electrode) 1203, the negative electrode 1204, the insulating plate 1205, and the wiring 1206 may be any part of a package mounted integrally.

Next, an operation of the laser apparatus 1000 will be described. When a voltage is applied between the negative electrode 1204 and the positive electrode 1203, a current is supplied to the semiconductor laser array 902. As a result, a population inversion is formed in the active layer of the semiconductor laser array 902. Once the population inversion is formed, spontaneous emission light with a center wavelength of 940 nm corresponding to a band gap in the semiconductor of the active layer is generated. The spontaneous emission light is confined within a resonator 1001 formed by the reflective layer r1 on the surface 1201 and the reflective layer r2 on the surface 1101, and reciprocates in the resonator 1001. The spontaneous emission light is amplified by stimulated emission upon passing through the active layer of the semiconductor laser array 902. Therefore, light intensity in the resonator 1001 is increased, laser oscillation begins. By increasing the reflectance of the electromagnetic wave having the wavelength of 940 nm in the reflective layer r1 and the reflective layer r2, intensity of the excitation light 903 can be increased.

Within the resonator 1001, the solid-state laser device 901 is arranged. The wavelength 940 nm of the electromagnetic wave oscillated by the resonator 1001 is included in an absorption band of the solid-state laser device 901. Therefore, a part of the excitation light 903 is absorbed by the solid-state laser device 901 and excites the laser medium of the solid-state laser device 901. The population inversion is also formed in the solid-state laser device 901, and the spontaneous emission light having the center wavelength of 1030 nm corresponding to the band gap of the laser medium is generated.

As shown in Fig. 1, on the surface 1103 of the solid-state laser device 901, the reflective layer r3 is formed, and on the surface 1104, the reflective layer r4 is formed. Thus, the spontaneous emission light in the solid-state laser device 901 is confined in the resonator 1002 formed by the reflective layer r3 on the surface 1103 and the reflective layer r4 on the surface 1104, and therefore reciprocates in the resonator 1002. The spontaneous emission light is amplified by the stimulated emission upon passing through the laser medium of the solid-state laser device 901. Therefore, the light intensity in the resonator 1002 is increased, and the laser oscillation begins. Thus, the laser light 905 is generated. The laser light 905 is emitted to outside of the solid-state laser device 901 in accordance with transmittance of the electromagnetic wave having the wavelength of 1030 nm in the reflective layer r4 on the surface 1104.

In the laser apparatus 1000, in order to correct a transverse mode in the excitation light, it is necessary to add the optical device. Also, in order to produce pulse laser light, a passive Q switch can be added to the laser apparatus 1000. Note that the passive Q switch needs to be arranged such that the optical axis of the passive Q switch is parallel or orthogonal to the optical axis of the resonator 1001. In order to obtain a high performance, the laser apparatus 1000 needs to perform precise alignment on components. The laser apparatus 1000 is large-sized, and it is not easy to realize a mass production of the apparatuses.

On the other hand, using the laser device according to the present disclosure, even without the use of the large laser apparatus, it is possible to obtain pulse laser light having large peak intensity in individual elements. Also, as described below, the laser device according to the present disclosure is formed by a simple stacked structure. The laser device according to the present disclosure realizes cost reduction and miniaturization of the individual laser devices and the laser apparatus using the laser devices.

Fig. 3 is a cross-sectional diagram schematically showing an example of the laser device according to a first embodiment of the present disclosure. The laser device 10 of Fig. 3 includes a semiconductor laser 1, a solid-state laser medium 2, and a Q switch 3. In the laser device 10, the semiconductor laser 1, the solid-state laser medium 2, and the Q switch 3 are arranged so as to stack in the z-axis direction. A shape of the laser device 10 can be substantially columnar. In this case, a surface of a z-axis negative direction side of the semiconductor laser 1 and a surface of a z-axis positive direction side of the Q switch 3 become bottom surfaces of the substantially columnar structure. Here, the substantially columnar shape includes, for example, shapes such as a substantially parallelepiped shape, a substantially cylindrical shape, a substantially elliptical columnar shape, a substantially triangular columnar shape, and a substantially polygonal columnar shape, and the shape of each bottom surface is not limited. Note that the laser device 10 may have other shape.

The semiconductor laser 1 corresponds to an excitation light source of the laser device 10. In the semiconductor laser 1, at least a part of the surface in the z-axis positive direction is an exit surface of the excitation light. The semiconductor laser 1 is, for example, a surface emitting semiconductor laser having an oscillation wavelength of 940 nm mainly composed of AlGaAs. As the semiconductor laser 1, it is possible to use a surface emitting semiconductor laser of a surface emitting type or a surface emitting semiconductor laser of a back emitting type. As a material of the semiconductor laser 1, for example, InGaAs, GaP, GaAs, InGaP or combinations thereof can be used. Note that the type of the material of the semiconductor laser 1 is not limited. Furthermore, as the excitation light source of the laser device 10, light sources other than the semiconductor laser may be used.

The solid-state laser medium 2 includes, for example, YAG (yttrium aluminum garnet) crystal doped with Yb (yttrium). In this case, the oscillation wavelength of the solid-state laser medium 2 is 1030 nm. For example, as the laser medium of the solid-state laser medium 2, at least one of materials of Nd:YAG, Nd:YVO4, Nd:YLF, Nd:glass, Yb:YAG, Yb:YLF, Yb:FAP, Yb:SFAP, Yb:YVO, Yb:glass, Yb:KYW, Yb:BCBF, Yb:YCOB, Yb:GdCOB, and YB:YAB can be used. The solid-state laser medium 2 may be a laser medium of a four-level system, or may be a laser medium of a three-level system. Note that the type of the laser medium used in the solid-state laser medium 2 is not limited.

The Q switch 3 is a passive Q switch device (saturable absorber). The Q switch 3 includes, for example, YAG (Cr:YAG) crystal doped with Cr (chromium). The Q switch 3 shows a saturable absorption characteristic with respect to the light intensity of the laser light passing through the Q switch 3. It is also possible to use V:YAG as the saturable absorber of the Q switch 3. Note that other types of saturable absorbers may be used as the Q switch 3. Furthermore, as the Q switch 3, it does not prevent the use of an active Q switch device.

In the laser device 10, unlike the laser apparatus 1000, both of the optical axis of the excitation light and the optical axis of the laser light generated are in the z-axis direction. That is, in the laser device according to the present disclosure, the optical axis of the excitation light and the optical axis of the laser light are coaxial.

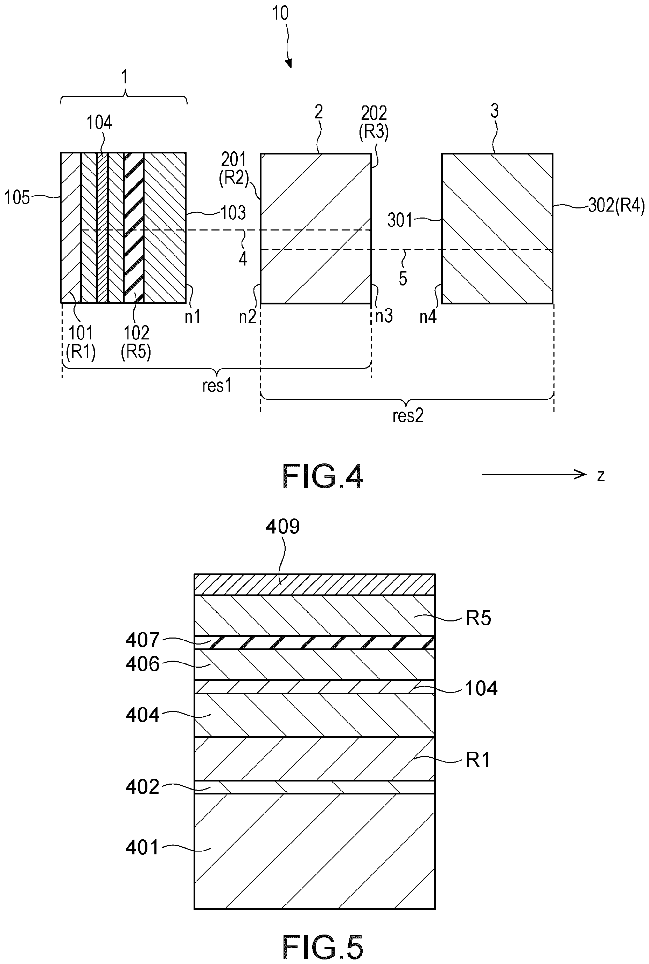

Fig. 4 is an exploded diagram showing an example of a laser device 10 according to the present disclosure. In Fig. 4, for a purpose of description, the laser device 10 is shown divided into parts: the semiconductor laser 1, the solid-state laser medium 2, and the Q switch 3. Note that the actual laser device 10 may have a structure in which there is no gap between layers. On the other hand, as shown in Fig. 4, adoption of a configuration having a gap between the components is not prohibited.

In the semiconductor laser 1, an active layer 104 is formed between the surface 103 facing to the solid laser medium 2 (z-axis positive direction side) and the surface 105 opposite to the solid laser medium 2 (z-axis negative direction side). A reflective layer R1 with respect to the electromagnetic wave having the wavelength of 940 nm is formed on the surface 105 of the semiconductor laser 1 or formed in an inner layer 101 between the surface 105 and the active layer 104.

Furthermore, a reflective layer R5 with respect to the electromagnetic wave having the wavelength of 940 nm is formed on the surface 103 of the semiconductor laser 1 or formed in an inner layer 102 between the surface 103 and the active layer 104. In addition, a reflective layer R3 with respect to the electromagnetic wave of 940 nm is formed on the surface 202 of the solid-state laser medium 2 facing to the Q switch 3 (z-axis positive direction side). The reflectance of the reflective layer R1 with respect to the electromagnetic wave having the wavelength of 940 nm may be higher than that of the reflective layer R5. That is, the reflective layer R5 may be a semi-transmissive layer that transmits a part of the electromagnetic wave having the wavelength of 940 nm. The reflective layer R3 transmits at least a part of the electromagnetic wave having the wavelength of 940 nm. For example, the transmittance of the electromagnetic wave having the wavelength of 940 nm in the reflective layer R3 may be set to have a value higher than that of the reflective layer R1 and lower than that of the reflective layer R5. On the other hand, in order to increase an electric field of oscillation light in the active layer 104 and obtain a laser gain, the reflectance of the reflective layer R1 and the reflective layer R3 with respect to the electromagnetic wave having the wavelength of 940 nm can be increased.

In the laser device 10, an optical resonator res1 is formed by the reflective layer R1 and the reflective layer R3. The optical resonator res1 is capable of resonating the electromagnetic wave having the wavelength of 940 nm.

On the surface 103 of the semiconductor laser 1, an anti-reflective film n1 with respect to the electromagnetic waves having the wavelength of 940 nm is formed. The anti-reflective film n1 can be formed on a solid laser medium 2 side (z-axis positive direction side) from the reflective layer R5. An anti-reflective film n2 with respect to the electromagnetic wave having the wavelength of 940 nm is formed on the surface 201 of the solid-state laser medium 2 facing to the semiconductor laser 1 (negative z-axis direction side). Note that at least one of the anti-reflective film n1 and the anti-reflective film n2 may be omitted.

On the surface 201 of the solid-state laser medium 2 facing to the semiconductor laser 1, a reflective layer R2 with respect to the electromagnetic wave having the wavelength of 1030 nm is formed. In a case where the anti-reflective film n2 is formed on the surface 201, the reflective layer R2 can be formed on the solid laser medium 2 side (z-axis positive direction side) from the anti-reflective film n2. Furthermore, on the surface 302 of the Q switch 3 opposite to the solid-state laser medium 2 (z-axis positive direction side), a reflective layer R4 with respect to the electromagnetic wave having the wavelength of 1030 nm is formed. Reflectance of the reflective layer R2 with respect to the electromagnetic waves having the wavelength of 1030 nm may be higher than that of the reflective layer R4. That is, the reflective layer R4 may be a semi-transmissive layer that transmits a part of the electromagnetic wave having the wavelength of 1030 nm.

In the laser device 10, an optical resonator res2 is formed by the reflective layer R2 and the reflective layer R4. The optical resonator res2 is capable of resonating the electromagnetic wave having the wavelength of 1030 nm.

On the surface 202 of the solid-state laser medium 2 facing to the Q switch 3 (z-axis positive direction side), an anti-reflective film n3 with respect to the electromagnetic wave having the wavelength of 1030 nm is formed. The anti-reflective film n3 may be formed on a Q switch 3 side (z-axis positive direction side) from the reflective layer R3. Alternatively, the anti-reflective film n3 may be formed on a solid-state laser medium 2 side (z-axis negative direction side) from the reflective layer R3. Furthermore, on the surface 301 of the Q switch 3 facing to the solid-state laser medium 2 (z-axis negative direction side), an anti-reflective film n4 with respect to the electromagnetic wave having the wavelength of 1030 nm is formed. Note that at least one of the anti-reflective film n3 and the anti-reflective film n4 may be omitted.

The above-described reflective layers R1-R5 are, for example, distributed Bragg reflectors (DBRs). The DBR refers to a reflector in which two types of media with different refractive indices are alternately formed at an optical film thickness of 1/4 wavelength. The above-described anti-reflective films n1-n4 are multilayer films including, for example, a silicon compound or magnesium fluoride. By providing the anti-reflective films, it is possible to increase the transmittance of the electromagnetic wave at interfaces.

The semiconductor laser 1 and the solid-state laser medium 2 may be bonded. Similarly, the solid-state laser medium 2 and the Q switch 3 may be bonded. In this case, the components may be bonded together by a bonding process. Alternatively, mechanical bonding may also be performed to fix the components together. Here, examples of the bonding process include normal temperature bonding, atomic diffusion bonding, and plasma bonding. Note that other types of processes may be used.

Next, an operation of the laser device 10 will be described.

Excitation light 4 generated by the semiconductor laser 1 is confined in the optical resonator res1 and reciprocates in the optical resonator res1. An absorption band of the solid-state laser medium 2 includes the oscillation wavelength of 940 nm of the semiconductor laser 1. Thus, the solid-state laser medium 2 in the optical resonator res1 is excited, and the population inversion is formed in the solid-state laser medium 2. Since the excitation light 4 is amplified by the stimulated emission, the optical resonator res1 laser-oscillates at the wavelength of 940 nm. The semiconductor laser 1 may be oscillatable in the optical resonator res1 including the solid-state laser medium 2. In a case where a part of the electromagnetic wave having the wavelength of 940 nm is transmitted through the reflective layer R5, the semiconductor laser 1 may not oscillate alone. Therefore, as the semiconductor laser 1, it is not necessary to use a semiconductor laser capable of oscillating alone.

A part of the light of the optical resonator res1 transmitted through the reflective layer R3 enters the Q switch 3 in the optical resonator res2. The entered light begins to reciprocate in the optical resonator res2 including the solid-state lasing medium 2 and the Q switch 3. Since the Q switch 3 absorbs the light when the light intensity increases and excites electrons at a ground level, the oscillation in the optical resonator res2 is temporarily suppressed. In the solid-state laser medium 2, the stimulated emission is suppressed and the electrons in an excited level are increased. After a certain period of time is elapsed, an excitation level of the Q switch 3 is filled with the electrons, an absorption rate of the light by the Q switch 3 is reduced. The stimulated emission is generated in the solid-state laser medium 2 and the optical resonator res2 laser-oscillates at the wavelength of 1030 nm. At this time, energy stored in the excitation level of the solid-state laser medium 2 is emitted to outside of the laser device 10 via the surface 302 as pulse laser light 5.

When the pulse laser light 5 is emitted, the light intensity in the optical resonator res2 is reduced. Thus, vacancy is made in the excitation level of the Q switch 3 and the absorption rate of light by the Q switch 3 is increased again. The laser light of the optical resonator res1 transmitted through the reflective layer R3 continues to feed to the optical resonator res2. Therefore, the light intensity in the optical resonator res2 increases again and the above-described processes are repeated. Thus, the laser device 10 repeatedly emits the pulse laser light 5.

As described above, the component that changes an optical loss due to absorption depending on the light intensity in the optical resonator and generates the pulse laser light is referred to as the passive Q switch. In a case where the passive Q switch is used, the higher the gain of the solid-state laser medium 2 is, the smaller a pulse time width of the laser light generated is. On the other hand, the pulse time width of the laser light generated is proportional to a resonator length of the optical resonator res2.

In the laser device 10, the solid-state laser medium 2 is shared by the optical resonator res1 and the optical resonator res2. Excitation regions in the solid-state laser medium 2 are limited to inside of a mode of the excitation light 4, it is possible to increase a gain density. Furthermore, in the laser device 10, the solid-state laser medium 2 and the Q switch 3 combines a function of a pair of reflectors in the optical resonator res2. Therefore, it is easy to shorten the resonator length of the optical resonator res2 and it is possible to reduce the size of the laser device. The laser device 10 can generate the pulse laser light having a short pulse time width and the large peak intensity. In particular, in a case where the laser device 10 is used for various processing, a short pulse time width contributes to improving machining accuracy. On the other hand, the magnitude of the peak intensity of the pulse contributes to shortening a processing time.

Increasing the gain of the solid-state laser medium 2, a repetition frequency of the pulse laser light 5 is increased. As described above, in the laser device 10, since the gain density of the solid-state laser medium 2 is increased, it is possible to increase the repetition frequency of the pulse laser light 5.

Next, an example of a method for manufacturing the laser device 10 will be described.

The cross-sectional diagram of Fig. 5 shows an example of a method of manufacturing the semiconductor laser. Hereinafter, an example of a method for manufacturing the semiconductor laser 1 will be described with reference to Figs. 5 to 12. Incidentally, when described as "upper" in the description of the manufacturing method, it means an upper side of a paper surface.

First, a contact layer 402 is formed on a semiconductor substrate 401. The semiconductor substrate 401 is, for example, an n-type GaAs substrate. Note that the semiconductor substrate 401 may be other types of a compound semiconductor or a silicon semiconductor. As the contact layer 402, for example, an n-type semiconductor can be used. For example, silicon can be doped with P (phosphorus) or As (arsenic) to form an n-type semiconductor. Furthermore, a reflective layer 403 is formed on the contact layer 402. The reflective layer 403 is, for example, the distributed Bragg reflector (DBR) obtained by laminating alternately different semiconductor materials at the optical film thickness of 1/4 wavelength. The reflective layer 403 may be the DBR formed by the n-type semiconductor. In this case, the reflective layer 403 corresponds to a an n-DBR layer.

On the reflective layer 403, a cladding layer 404 is formed. An active layer 405 is formed on the cladding layer 404. Furthermore, on the cladding layer 404, the active layer 405 is formed. Furthermore, on the active layer 405, the cladding layer 406 is formed. The active layer 405 is formed of a material having the band gap smaller than and having the refractive index greater than the cladding layer 404 and the cladding layer 406. The active layer 405 including quantum wells or multiple quantum wells may be formed.

On the cladding layer 406, a reflective layer 408 is formed. The reflective layer 408 is, for example, the DBR (p-DBR) in which different p-type compound semiconductors are alternately stacked in the optical film thickness of 1/4 wavelength. For example, reflective layers 408 can be formed by AlAs or AlGaAs. Note that the material of the reflective layer 408 is not limited.

On the reflective layer 408, a contact layer 409 is formed. As the contact layer 409, for example, a p-type semiconductor can be used. For example, silicon can be doped with B (boron) or Al (aluminum) to form the p-type semiconductor. The contact layer 409 of the p-type semiconductor realizes an ohmic contact with the electrode.

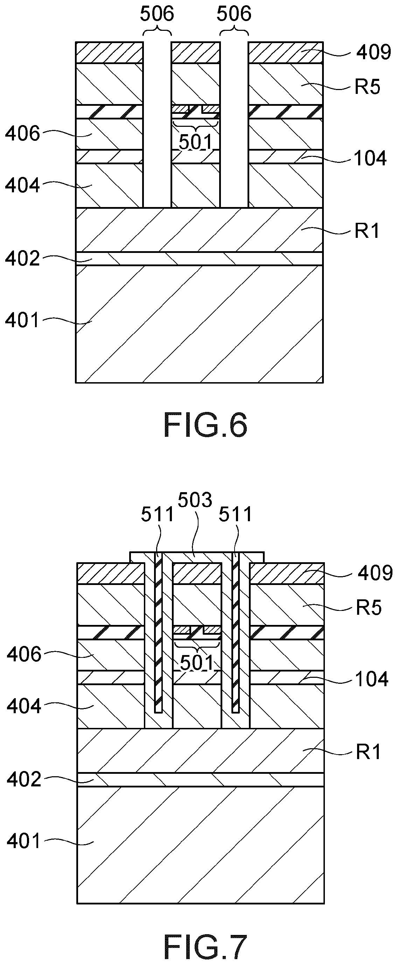

Note that a part of the reflective layer 408 may be oxidized to form an oxide layer 407. For example, AlAs in the reflective layer 408 can be selectively oxidized to form an Al₂O₃ layer. Note that the oxide layer 407 is not formed over an entire surface, and an unoxidized opening may be left on a part of the surface. Thus, a constriction structure 501 of Fig.6 can be formed. The constriction structure 501 constricts the current in the vicinity of the active layer 405 and realizes efficient current injection into the active layer 405. By providing the constriction structure 501, the semiconductor laser 1 can be operated at a low threshold current. In addition, since the refractive index of the oxide layer 407 is smaller than that of surroundings, a light confinement effect can be obtained.

For example, after a mesa post structure is formed in an epitaxial multilayer film including the layer to be oxidized by etching, the constricted structure 501 can be formed. The constriction structure 501 is formed, for example, by selectively oxidizing the layer to be oxidized from each side surface of a trench under a pressurized water vapor atmosphere. The cross-sectional diagram of Fig. 6 shows the state after the mesa post structure and the constriction structure 501 are formed in Fig. 5. In the mesa post structure of Fig. 6, from the contact layer 409 to the cladding layer 404 is etched to form a trench 506. Then, at bottom surfaces of the trench 506, a part of the reflective layer 403 is exposed. Note that the mesa post structure and the constriction structure 501 may be formed by a method different from those described above.

In order to form each of the layers described above, for example, molecular beam epitaxy (MBE) or organometallic vapor deposition (MOCVD) may be used. Note that the layer may be formed by other technologies.

Next, steps of forming the electrode of the semiconductor laser 1 will be described.

After the mesa post structure and the constricted structure 501 are formed, a positive electrode (p-electrode) 503 is formed along an outer periphery of the mesa post structure. The cross-sectional diagram of Fig. 7 shows a state after the positive electrode 503 of Fig. 6 is formed. In Fig. 7, the positive electrode 503 is formed in the trench 506 surrounding the mesa post structure, in an upper part of the mesa post structure, and in the vicinity of a trench opening. The positive electrode 503 is in contact with the reflective layer 408 (p-DBR) and is formed of a conductive material such as metal. As shown in Fig. 7, insulation 511 may be formed in the positive electrode 503 so as to penetrate from an upper surface of the positive electrode 503 to a lower part of the active layer 405. As the insulation 511, for example, SiN, SiO₂, or polyimide can be used. Note that the insulation 511 may be made of other material. Incidentally, without forming the insulation 511, a space corresponding to the insulation 511 of Fig. 7 may be a gap.

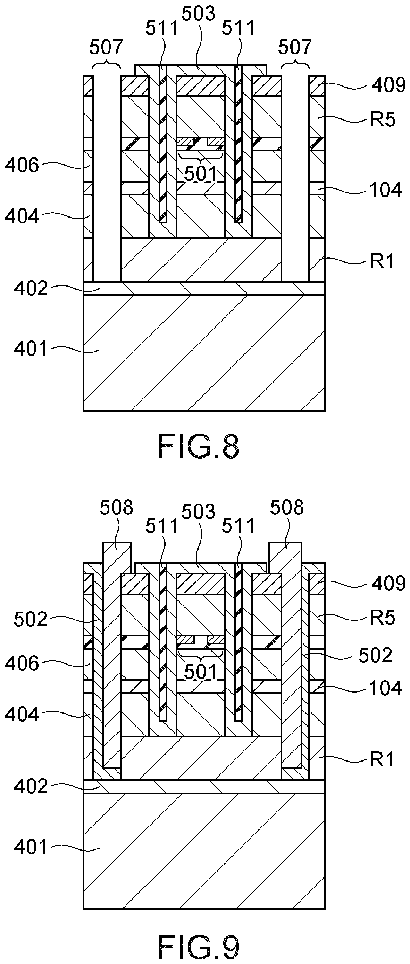

Then, as shown in the cross-sectional diagram of Fig. 8, a trench 507 is formed on outside of the positive electrode 503 by etching. In the trench 507 of Fig. 8, the contact layer 409 to the reflective layer 403 are etched. Furthermore, at a bottom surface of the trench 507, a part of the contact layer 402 is exposed. For example, the trench 507 can be formed by reactive ion etching. Note that the trench may be formed by other type of method.

As shown in the cross-sectional diagram of Fig. 9, the bottom part of the trench 507, a side surface at an outer peripheral side of the trench 507 and a portion on the outer peripheral side of the trench 507 of the contact layer 409, a negative electrode (n-electrode) 502 is formed. The negative electrode 502 is in contact with the reflective layer 403 (n-DBR) and is formed of a conductive material such as metal. Furthermore, insulation 508 is formed where the negative electrode 502 of the trench 507 is not formed including the side surface at an inner peripheral side of the trench 507. The insulation 508 is made of, for example, SiN, SiO₂, or polyimide. Note that the insulation 508 may be formed of other material. Incidentally, without forming the insulation 508, a space corresponding to the insulation 508 of Fig. 9 may be a gap.

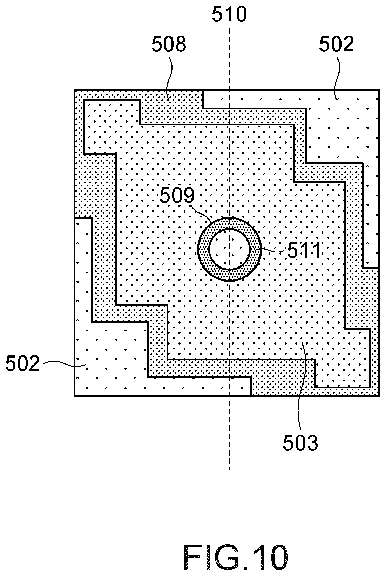

Fig. 10 shows a structure when viewed from an upper direction in plan view of Fig 9. A dashed line 510 in Fig. 10 shows a cutting position of the cross-sectional diagram of Fig. 9. As shown in Fig. 10, the insulation 508 prevents a direct contact between the positive electrode 503 and the negative electrode 502. Positions and shapes of the positive electrode 503 and the negative electrode 502 shown in Fig. 10 are merely examples. Therefore, the positions and shapes of the positive electrode 503 and the negative electrode 502 may be different.

An annular opening 509 is provided in the positive electrode 503 of Fig. 10. In the opening 509, the insulation 511 is formed in an annular shape. By forming the insulation 511 in the annular shape, it is possible to emit a beam of laser light in a circular shape. An opening having a different shape in plan view may be formed in the positive electrode 503. Depending on the direction in which the laser light is emitted, it may be formed an opening in a direction different from Fig. 10. Note that the opening 509 does not necessarily need to be filled with a material. Also, the opening may be omitted.

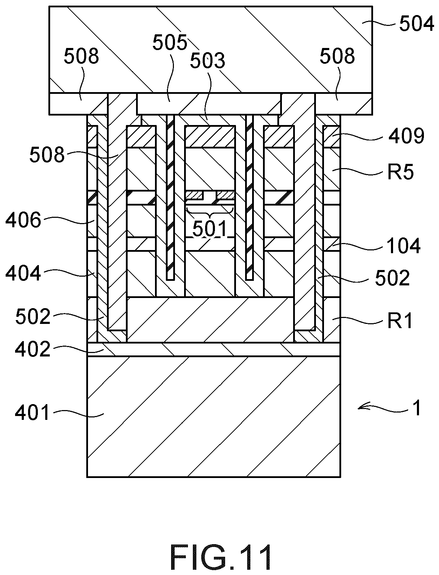

Finally, the submount 504 is mounted on upper sides of the positive electrode 503 and the negative electrode 502. Fig. 11 is a cross-sectional diagram showing an example of the semiconductor laser 1 after mounting the submount 504. As shown in Fig. 11, the positive electrode 503 and the negative electrode 502 are in contact with an electrode 505 of the submount 504. The semiconductor laser 1 operates by an electrical signal supplied from the electrode 505 of the submount 504.

In a case where the semiconductor laser 1 is the surface emitting semiconductor laser of the back emitting type, the laser light is emitted in a lower direction of the paper surface in Fig. 11 through the cladding layer 404, the reflective layer 403, and the semiconductor substrate 401. On the other hand, in a case where the semiconductor laser 1 is the surface emitting semiconductor laser of the surface emitting type, the laser light is emitted in an upper direction of the paper surface in Fig. 11.

In a case where the semiconductor laser 1 is the surface emitting semiconductor laser of the surface emitting type, so that the laser light can be emitted, an opening may be provided in the positive electrode 503, the electrode 505 and the submount 504. For example, an opening having a substantially circular shape in plan view or a substantially annular shape in plan view can be formed. Note that the shape of the opening is not limited. To form an opening for laser light emission, etching may be performed. A portion where the laser light is emitted may be formed of a transparent material with respect to the wavelength of the laser light. For example, if laser light of near-infrared radiation is emitted, the portion where the laser light is emitted can be formed by GaAs.

In the following, in an example case where the semiconductor laser 1 is the surface emitting semiconductor laser of the back emitting type, a method of manufacturing the laser device 10 will be described. Note that the semiconductor laser 1 may be the surface emitting semiconductor laser of the surface emitting type or other type of semiconductor laser. As described above, as the excitation light source, a light source other than the semiconductor laser may be used.

The solid-state laser medium 2 is arranged with respect to the semiconductor laser 1 on a lower side of the paper surface in Fig. 11. That is, the solid-state laser medium 2 is arranged to face the semiconductor substrate 401 of the semiconductor laser 1. The solid-state laser medium 2 may be bonded directly to the semiconductor substrate 401. Alternatively, the solid-state laser medium 2 and the semiconductor substrate 401 may be connected indirectly through other structure. Note that the semiconductor substrate 401 does not necessarily have to be in close contact with the solid-state laser medium 2. Therefore, a space may exist between the solid-state laser medium 2 and the semiconductor substrate 401. As the solid-state laser medium 2, a solid-state laser medium such as Yb:YAG crystal can be used. Incidentally, when the surface emitting semiconductor laser of the surface emitting type is used, the solid-state laser medium 2 is arranged with respect to the semiconductor laser 1 on the upper side of the paper surface in Fig. 11.

On the surface of the solid-state laser medium 2 facing to the semiconductor laser 1 (surface 201 in Fig. 4), the reflective layer R2 with respect to the oscillation wavelength of the solid-state laser medium 2 is formed. Incidentally, on the surface of the semiconductor laser 1 facing to the solid-state laser medium 2 (surface 103 in Fig. 4), a reflective layer with respect to the oscillation wavelength of the solid-state laser medium 2 may be formed.

Furthermore, on at least one of the surface of the semiconductor laser 1 facing to the solid-state laser medium 2 (surface 103 in Fig. 4) or the surface of the solid-state laser medium 2 facing to the semiconductor laser 1 (surface 201 in Fig. 4), the anti-reflective film with respect to the oscillation wavelength of the semiconductor laser 1 may be formed.

The Q switch 3 is arranged to face the opposite surface of the semiconductor laser 1 of the solid-state laser medium 2. The Q switch 3 may be bonded directly to the solid-state laser medium 2. Alternatively, the Q switch 3 and the solid-state laser medium 2 may be connected indirectly through other structure. Note that the Q switch 3 does not necessarily have to be in close contact with the solid-state laser medium 2. Therefore, a space may exist between the Q switch 3 and the solid-state laser medium 2. As the Q switch 3, a saturable absorber such as Cr:YAG crystal can be used.

On the surface of the solid-state laser medium 2 facing to the Q switch 3 (surface 202 in Fig. 4), the reflective layer R3 with respect to the oscillation wavelength of the semiconductor laser 1 is formed. Incidentally, on the surface of the Q switch 3 facing to the solid-state laser medium 2 (surface 301 in Fig. 4), a reflective layer with respect to the oscillation wavelength of the semiconductor laser 1 may be formed.

Furthermore, on at least one of the surface of the solid-state laser medium 2 facing to the Q switch 3 (surface 202 in Fig. 4) or the surface of the Q switch 3 facing to the solid-state laser medium 2 (surface 301 in Fig. 4), the anti-reflective film with respect to the oscillation wavelength of the solid-state laser medium 2 may be formed. On the surface of the Q switch 3 opposite to the solid-state laser medium 2 (surface 302 in Fig. 4), the reflective layer R4 with respect to the oscillation wavelength of the solid-state laser medium 2 is formed.

Similar to the manufacturing steps of the semiconductor laser 1, by the bonding process (e.g., normal temperature bonding, atomic diffusion bonding, plasma bonding) or by mechanical bonding, it is possible to perform bonding between the components.

Since the laser device 10 is formed by laminating a plurality of materials, it is possible to manufacture a plurality of laser devices 10 in parallel. For example, when a semiconductor substrate 401A having an area capable of forming a plurality of semiconductor lasers 1 is prepared, it is possible to perform the above-described manufacturing steps for a plurality of locations of the semiconductor substrate 401A. For example, on the semiconductor substrate 401A, a plurality of semiconductor lasers 1 can be formed in an array shape. Note that a plurality of semiconductor lasers 1 in an arrangement different from this may be formed on the semiconductor substrate 401A. Once the plurality of semiconductor lasers 1 are formed on the semiconductor substrate 401A, steps of forming the reflective layer described above, bonding the solid-state laser medium 2 and the Q switch 3, and the like are performed. As a result, a plurality of laser devices 10 can be formed at the same time.

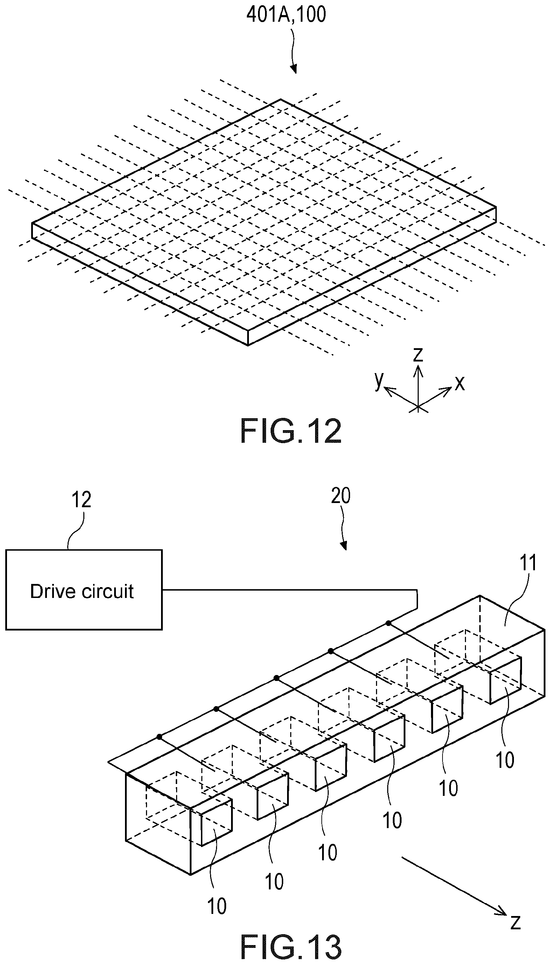

Then, as shown in Fig. 12, a plate structure 100 in which a plurality of laser devices 10 are integrally formed can be diced and separated into individual laser devices 10. For example, the structure 100 can be cut by a diamond blade or a laser cutter.

As described above, when the surface emitting semiconductor laser of the back emitting type is used, it is easy to perform electrical wiring to the electrode. Note that the above-described manufacturing method and the configuration of the laser device 10 are merely examples. Therefore, at least a part of the manufacturing method of the laser device may be different from the above. In addition, the shape of the structure to be actually manufactured may be different from each of the above-described drawings.

A method of manufacturing a laser device according to the present disclosure may manufacture a plurality of laser devices by forming a laminated structure in which a plurality of materials are stacked on a semiconductor substrate and thereafter dicing. Here, the laser device may include the excitation light source having the first reflective layer with respect to the first wavelength, the laser medium having the second reflective layer with respect to the second wavelength on the first surface facing to the excitation light source and the third reflective layer with respect to the first wavelength on the second surface opposite to the first surface, and the saturable absorber having the fourth reflective layer with respect to the second wavelength on a third surface opposite to the laser medium.

Here, the configuration of the laser device according to the present disclosure will be summarized.

The laser device according to the present disclosure may include the excitation light source, the laser medium, and the saturable absorber. The excitation light source has the first reflective layer with respect to the first wavelength. The laser medium has the second reflective layer with respect to the second wavelength on the first surface facing to the excitation light source and the third reflective layer with respect to the first wavelength on the second surface opposite to the first surface. The saturable absorber has the fourth reflective layer with respect to the second wavelength on the third surface opposite the laser medium. The third reflective layer may transmit a part of the first wavelength. The fourth reflective layer may transmit a part of the second wavelength. The first wavelength may be a wavelength of the excitation light generated by the excitation light source. The second wavelength may be an oscillation wavelength of the laser medium. At least a part of the fourth surface facing to the laser medium of the excitation light source may be the exit surface of the excitation light.

The semiconductor laser 1 described above is an example of the excitation light source. The solid-state laser medium 2 is an example of the laser medium. The Q switch 3 is an example of the saturable absorber. The reflective layer R1 is an example of the first reflective layer. The surface 201 in Fig. 4 is an example of the first surface. The reflective layer R2 is an example of the second reflective layer. The surface 202 is an example of the second surface. The reflective layer R3 is an example of the third reflective layer. The surface 302 is an example of the third surface. The reflective layer R4 is an example of the fourth reflective layer. The surface 103 is an example of the fourth surface.

Furthermore, the excitation light source may have a fifth reflective layer with respect to the first wavelength on the fourth surface facing to the laser medium. The fifth reflective layer may transmit a part of the first wavelength. The excitation light source may be a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer. Transmittance of the fifth reflective layer with respect to the first wavelength may be higher than that of the first reflective layer. Furthermore, reflectance of the first reflective layer with respect to the first wavelength may be higher than that of the fifth reflective layer.

The surface 103 in Fig. 4 is an example of the fifth surface. The reflective layer R5 is an example of the fifth reflective layer. The reflective layer 408 (p-DBR) is an example of the p-type semiconductor multilayer reflective layer. The reflective layer 403 (n-DBR) is an example of the n-type semiconductor multilayer reflective layer. The active layer 405 is an example of the active layer including the quantum well.

The laser device according to the present disclosure may have a first anti-reflective film with respect to the first wavelength between the excitation light source and the laser medium. The laser device according to the present disclosure may have a second anti-reflective film with respect to the second wavelength between the laser medium and the saturable absorber.

The above-described anti-reflective film n1 and the anti-reflective film n2 are both examples of the first anti-reflective film. The anti-reflective film n3 and the anti-reflective film n4 are both examples of the second anti-reflective film.

Next, an example of the laser apparatus using the laser device 10 will be described.

Fig. 13 shows an example of a multi-beam laser device. A laser apparatus 20 of Fig. 13 includes a plurality of laser devices 10 arranged in a one-dimensional array, a support portion 11 for supporting the plurality of laser devices 10, and a drive circuit 12. For example, a periphery of each laser device 10 may be wrapped with a highly thermally conductive material such as a metal sheet (metal foil), and housed in the support portion 11. The support portion 11 is formed of, for example, a material excellent in heat resistance such as a thermosetting resin, a ceramic, or a metal. Note that the support portion 11 may be formed of other material.

The plurality of laser devices 10 are electrically connected to the drive circuit 12. The drive circuit 12 is configured to supply an electrical signal for driving to the plurality of laser devices 10. Thus, the plurality of laser devices 10 can emit light at the same time. In the laser apparatus 20 of Fig. 13, the laser light is emitted in the z-axis positive direction.

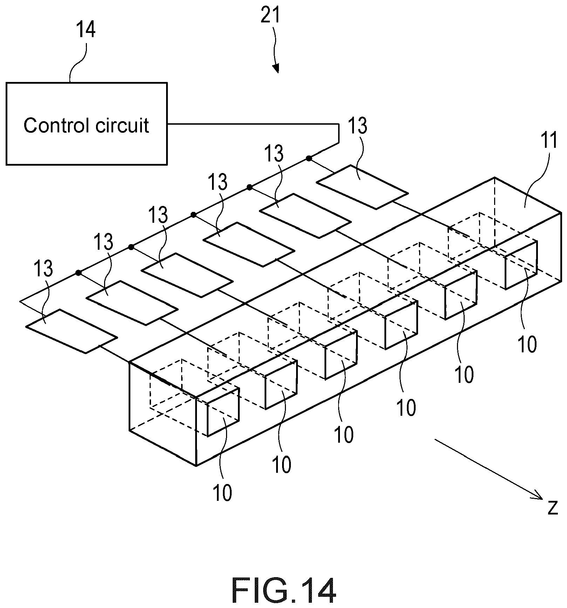

Fig. 14 shows an example of a laser apparatus according to Modification 1. A laser apparatus 21 of Fig. 14 includes a plurality of laser devices 10 arranged in a one-dimensional array, the support portion 11 for supporting the plurality of laser devices 10, a plurality of drive circuits 13, and a control circuit 14. Configurations of the plurality of laser devices 10 and the support portion 11 are the same as the laser apparatus 20 (Fig. 13). In the laser apparatus 21, individual drive circuits 13 corresponding to the respective laser devices 10 are provided. Then, each of the laser devices 10 is electrically connected to the corresponding drive circuit 13. As shown in Fig. 14, the control circuit 14 electrically connected to the plurality of driving circuits 13 may be provided.

Each drive circuit 13 is configured to supply an electrical signal to any of the laser devices 10. On the other hand, the control circuit 14 is configured to transmit a control signal to the plurality of driving circuits 13 or at least one of the driving circuits 13. For example, the control circuit 14 may control at least one of the drive circuits 13, and causes at least one of the laser device 10 to emit light. Furthermore, the control circuit 14 may control each drive circuit 13 so that a part of the laser devices 10 selectively emits light among the plurality of laser devices 10. Also in Fig. 14, similar to Fig. 13, the laser light is emitted in the z-axis positive direction.

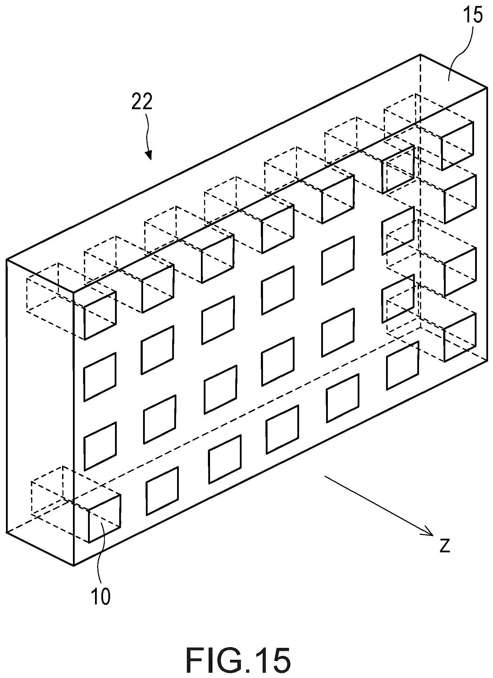

Fig. 15 shows an example of a laser apparatus according to Modification 2. A laser apparatus 22 of Fig. 15 includes a plurality of laser devices 10 arranged in a two-dimensional array, and a support portion 15 for supporting the plurality of laser devices 10. The plurality of laser devices 10 of the laser device 22 may be connected to a common drive circuit (not shown), as in the laser apparatus 20 (Fig. 13). Furthermore, the plurality of laser devices 10 of the laser apparatus 22 may be connected to individual drive circuits (not shown), as in the laser apparatus 21 (Fig. 14). Also in Fig. 15, the laser light is emitted in the z-axis positive direction.

Thus, the laser apparatus according to the present disclosure may further include a drive circuit configured to supply an electrical signal for driving to at least one of the laser devices.

The laser apparatuses illustrated in Figs. 13 to 15 can be applied to a plurality of fields such as microfabrication, lithography, and medical treatment. In particular, in the field of microfabrication, by using a laser apparatus in which a plurality of laser devices are arranged, it is possible to achieve both high machining accuracy and high energy output. Note that the arrangements of the plurality of laser devices 10 shown in Figs. 13 to 15 are only examples. Therefore, the laser apparatus may employ an arrangement of the laser devices 10 different from those described above. The plurality of laser devices 10 may be arranged periodically in the same row or in the same plane. Furthermore, the plurality of laser devices 10 may be arranged on the same plane at different densities depending on locations.

Next, modifications of the laser device according to the present disclosure.

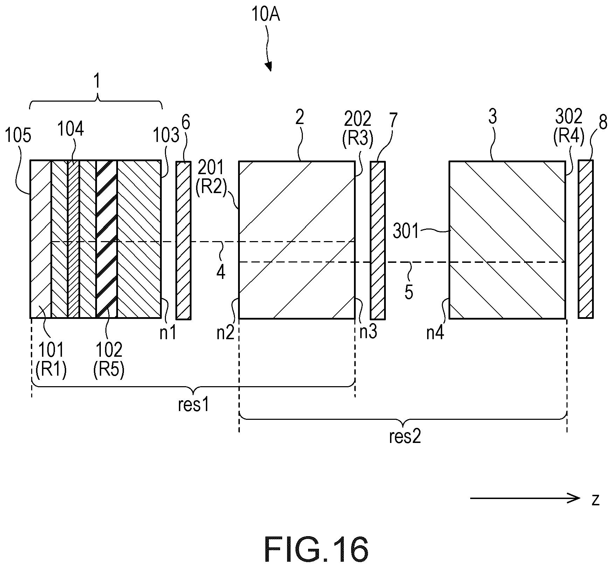

Fig. 16 is an exploded diagram showing an example of a laser device according to Modification 3. a laser device 10A of Fig. 16 is obtained by adding a radiator plate (heat sink) to the laser device 10 of Fig. 4. In the laser device 10A, a radiator plate 6 is arranged between the semiconductor laser 1 and the solid-state laser medium 2. Furthermore, in the laser device 10A, a radiator plate 7 is arranged between the solid-state laser medium 2 and the Q switch 3. Furthermore, a radiator plate 8 is arranged at a surface of the Q switch opposite to the solid-state laser medium 2 (z-axis positive direction side).

Incidentally, the numbers and the arrangements of the radiator plates shown in Fig. 16 are only an example. For example, the radiator plates may be arranged at positions different from those in Fig. 16. In addition, at least one of the radiator plates 6 to 8 may be omitted. As the radiator plates 6-8, for example, undoped YAG crystal, quartz, or sapphire may be used. Note that the material of the heat sinks 6 to 8 is not limited.

If necessary, various coatings may be applied to surfaces of the radiator plates 6 to 8. For example, an anti-reflective film with respect to the electromagnetic wave having the wavelength of 940 nm may be formed on at least one of the surface of the radiator plate 6 facing to the semiconductor laser 1 or the surface of the radiator plate 6 facing to the solid-state laser medium 2. Furthermore, an anti-reflective film with respect to the electromagnetic wave having the wavelength of 1030 nm may be formed on at least one of the surface of the radiator plate 7 facing to the solid-state laser medium 2 or the surface of the radiator plate 7 facing to the Q switch 3.

In the laser device, a temperature gradient may be generated due to such factors as a quantum defect due to a difference in photon energy of excitation light and oscillation light, and thermal relaxation phenomenon which does not contribute to stimulated emission and spontaneous emission. If there is the temperature gradient in the laser device, the refractive index of the material changes according to the temperature, and there is a possibility that a thermal lens effect is generated for the oscillation light. If the thermal lens effect is generated, the oscillation light is locally condensed in the laser device, which may damage the material. Therefore, as in Fig. 16, each laser device can be provided with the radiator plate to suppress a temperature rise in the laser device and to prevent generation of the thermal lens effect.

The manufacturing steps of the laser device 10A are the same as those of the above-described laser device 10, except that a step of bonding with the radiator plate or forming the radiator plate is added. Also, in the laser devices 20-22 described above, the laser device 10A of Fig. 16 may be used instead of the laser device 10.

The laser device according to the present disclosure may further include one or more radiator plates. The radiator plate may be arranged between the excitation light source and the laser medium, between the laser medium and the saturable absorber, or at least any position of a third surface of the saturable absorber.

Here, the semiconductor laser 1 is an example of the excitation light source. The solid-state laser medium 2 is an example of the laser medium. The Q switch 3 is an example of the saturable absorber. The surface 302 is an example of the third surface.

Depending on the application of the laser device and the laser apparatus, laser light having a wavelength different from that of the oscillation light of the solid-state laser medium may be required. Therefore, it is possible to generate laser light having a desired wavelength using a wavelength conversion material.

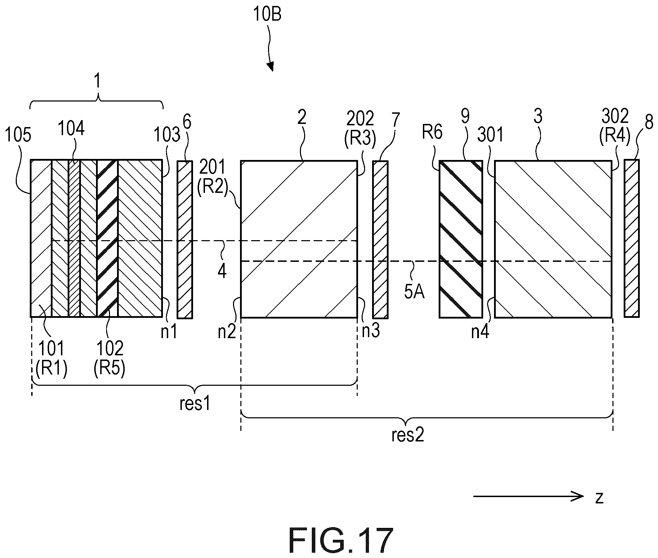

Fig. 17 is an exploded diagram showing an example of a laser device according to Modification 4. A laser device 10B of Fig. 17 is obtained by adding a wavelength converting material 9 to the laser device 10A of Fig. 16. The wavelength converting material 9 of Fig. 17 is arranged between the radiator plate 7 of the optical resonator res2 and the Q switch 3. Note that the arrangement of the wavelength conversion material may be different from this. For example, the wavelength conversion material may be arranged on the positive z-axis direction side from the Q switch 3. That is, the wavelength conversion material can be arranged at any position between the reflective layer R2 and the reflective layer R4 (in optical resonator res2).

Depending on the wavelength of the laser light to be generated, a type of the wavelength conversion material to be used can be selected. Examples of the wavelength conversion material include nonlinear optical crystal such as LiNbO₃, BBO, LBO, CLBO, BiBO, KTP, and SLT. As the wavelength conversion material, a phase matching material similar to these may be used. Note that the type of the wavelength conversion material is not limited. The oscillation light 5A of the optical resonator res2 is converted into laser light 5B having a wavelength λ_{c} by the wavelength converting material 9. The laser light 5B is emitted in the z-axis positive direction from the laser device 10B.

A reflective layer R6 for the laser light 5B having the wavelength λ_{c} may be formed on the surface of the wavelength converting material 9 facing to the semiconductor laser 1. In addition, an anti-reflective film with respect to the laser light 5B having the wavelength λ_{c} may be formed on at least one of a surface of the wavelength conversion material 9 facing to the Q switch 3, a surface of the Q switch 3 facing to the wavelength conversion material 9, a surface of the Q switch 3 opposite to the wavelength conversion material 9, a surface of the radiator plate 8 facing to the Q switch 3, and a surface of the radiator plate 8 opposite to the Q switch 3 may be formed with.

The manufacturing steps of the laser device 10B are the same as those of the above-described laser device 10A, except that a step of bonding with the wavelength conversion material 9 or forming the wavelength conversion material 9 is added. Also, in the laser devices 20-22 described above, the laser device 10B of Fig. 17 may be used instead of the laser device 10. Incidentally, Fig. 17 shows an example of the laser device including the plurality of radiator plates, but at least one of the radiator plates may be omitted. Furthermore, the radiator plates may be arranged at positions different from Fig. 17.

The laser device according to the present disclosure may further include the wavelength conversion material arranged between the second reflective layer and the fourth reflective layer. Furthermore, it may further include a sixth reflective layer with respect to the wavelength after conversion by the wavelength conversion material on the fifth surface facing to the excitation light source of the wavelength conversion material.

Here, the reflective layer R2 is an example of the second reflective layer. The reflective layer R4 is an example of the fourth reflective layer. The semiconductor laser 1 is an example of the excitation light source. The surface of the wavelength conversion material 9 of Fig. 17 in the z-axis negative direction side is an example of the fifth surface. The reflective layer R6 is an example of the sixth reflective layer.

The reflective layer R2 in the above-described laser device is arranged in the optical resonator res1. For this reason, it is desirable to increase the transmittance of the reflective layer R2 with respect to the electromagnetic wave having the first wave so as not to disturb the resonance of the electromagnetic wave having the first wave (e.g., 940 nm) in the optical resonator res1. On the other hand, the reflective layer R2 corresponds to one of the pair of reflectors in the optical resonator res2. In order to secure a gain in the optical resonator res2, it is desirable to increase the reflectance of the reflective layer R2 with respect to the electromagnetic wave having the second wavelength (e.g., 1030 nm). That is, it is necessary to design the reflective layer R2 considering two requirements: (1) the transmittance with respect to the first wavelength, and (2) the reflectance with respect to the second wavelength.

In the following, an example of the laser device in which the reflective layer is easily designed will be described. Here, a case where the first wavelength is 940 nm and the second wavelength is 1030 nm will be described as an example. The first wavelength is, for example, an oscillation wavelength of the semiconductor laser 1. The second wavelength is, for example, an oscillation wavelength of the solid-state laser medium 2. Note that the sizes of the first wavelength and the second wavelength are not limited.

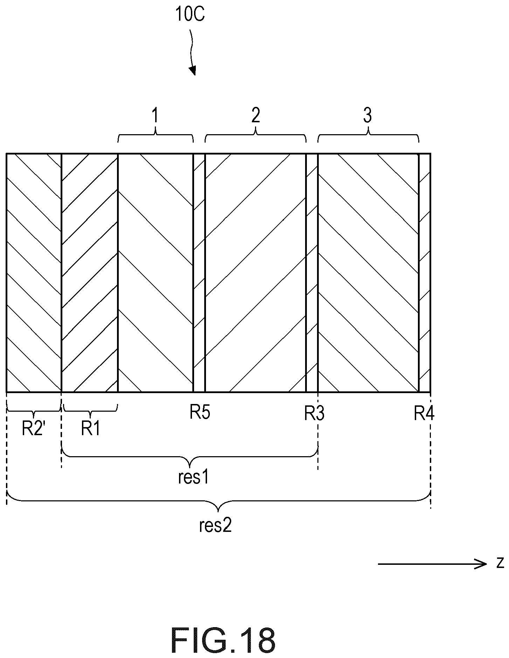

Fig. 18 is a cross-sectional diagram showing an example of a laser device according to Modification 5. In a laser device 10C of Fig. 18, similar to the laser devices shown in the respective drawings described above, the semiconductor laser 1, the solid-state laser medium 2, the Q switch 3 are arranged so as to stack in the z-axis direction.

The semiconductor laser 1 is an excitation light source configured to emit excitation light in the z-axis positive direction. The semiconductor laser 1 is, for example, the semiconductor having the oscillation wavelength of 940 nm mainly composed of AlGaAs. For example, as the semiconductor laser 1, a surface emitting semiconductor laser having a quantum well structure may be used. For example, as the semiconductor laser 1 of the laser device 10C, it is possible to use the semiconductor laser described in Figs. 5 to 11 described above. Note that, in the laser device 10C, an excitation light source other than the semiconductor laser may be used.

As the solid-state laser medium 2, for example, Yb:YAG can be used. Note that other types of laser media may be used as described above. As the Q switch 3, for example, Cr:YAG can be used. Note that other types of saturable absorbers such as V:YAG may be used as the Q switch 3 as described above.

On a surface of the semiconductor laser 1 opposite to the solid-state laser medium 2 (z-axis negative direction side), a reflective layer R2' and the reflective layer R1 are formed. The reflective layer R2' is a reflective layer with respect to an electromagnetic wave of 1030 nm (oscillation wavelength of solid-state laser medium 2). On the other hand, the reflective layer R1 is a reflective layer with respect to an electromagnetic wave of 940 nm (oscillation wavelength of semiconductor laser 1). The reflective layer R2' and the reflective layer R1 are, for example, distributed Bragg reflectors (DBRs).

Separate DBRs may be formed as the reflective layer R2' and the reflective layer R1. In this case, as in Fig. 18, the reflective layer R2' may be formed on the z-axis negative direction side from the reflective layer R1. The reflective layer R1 may be formed on the z-axis negative direction side from the reflective layer R2'. Incidentally, on the surface of the semiconductor laser 1 opposite to the solid-state laser medium 2 (z-axis negative direction side), a common DBR including functions of the reflective layer R2' and the reflective layer R1 may be formed. That is, on the surface of the semiconductor laser 1 opposite to the solid-state laser medium 2, a reflective layer (DBR) with respect to the electromagnetic wave of 940 nm and the electromagnetic wave of 1030 nm may be formed.

In any of the above cases, it can be said that the reflective layer R2' and the reflective layer R1 are formed coplanarly on the semiconductor laser 1.

Furthermore, the surface of the semiconductor laser 1 facing to the solid-state laser medium 2 (z-axis positive direction side), the reflective layer R5 is formed. The reflective layer R5 is a reflective layer with respect to the electromagnetic wave having the wavelength of 940 nm (oscillation wavelength of the semiconductor laser 1). The reflectance of the reflective layer R5 with respect to the electromagnetic wave having the wavelength of 940 nm may be set lower than that of the reflective layer R1. Furthermore, the reflective layer R5 may be a semi-transmissive layer that transmits a part of the electromagnetic wave having the wavelength of 940 nm. The semiconductor laser 1 of the laser device 10C may be oscillated in the optical resonator res1. Therefore, as the semiconductor laser 1, it is not necessary to use a semiconductor laser capable of oscillating alone. The reflective layer R5 is, for example, a DBR (p-DBR) in which p-type compound semiconductors differing in optical film thickness of 1/4 wave length are alternately stacked. For example, the reflective layers R5 can be formed of AlAs or AlGaAs. Note that the material of the reflective layer R5 is not limited.

The reflective layer R3 is formed on the surface between the solid-state laser medium 2 and the Q switch 3. The reflective layer R3 is a reflective layer with respect to the electromagnetic wave having the wavelength of 940 nm (oscillation wavelength of semiconductor laser 1). For example, DBR can be used as the reflective layer R3. The reflective layer R1 and the reflective layer R3 form the optical resonator res1. The reflective layer R3 transmits at least a part of the electromagnetic wave having the wavelength of 940 nm. For example, the transmittance of the electromagnetic wave having the wavelength of 940 nm in the reflective layer R3 can be set higher than that of the reflective layer R1 and lower than that of the reflective layer R5. The reflective layer R3 transmits at least a part of the electromagnetic wave of the oscillation wavelength of the semiconductor laser 1. Therefore, a part of the oscillation light in the optical resonator res1 can proceed to the Q switch 3 side.

On the surface of the Q switch 3 opposite to the solid-state laser medium 2 (surface at z-axis positive direction side), the reflective layer R4 is formed. The reflective layer R4 is a reflective layer with respect to the electromagnetic wave having the wavelength of 1030 nm (oscillation wavelength of solid-state laser medium 2). The reflective layer R2' and the reflective layer R4 form the optical resonator res2. From the reflective layer R4, a part of the oscillation light in the optical resonator res2 is emitted in the z-axis positive direction. For this reason, the reflective layer R4 may be a semi-transmissive layer that transmits a part of the electromagnetic wave having the wavelength of 1030 nm. Furthermore, the reflectance of the reflective layer R4 with respect to the electromagnetic wave having the wavelength of 1030 nm may be set lower than that of the reflective layer R2'.

In the semiconductor laser device 10C of Fig. 18, the light reflector res2 is arranged within the light reflector res1. The above-described reflective layer R2 is arranged with respect to the active layer of the semiconductor laser 1 on the z-axis positive direction side. On the other hand, the reflective layer R2' (second reflective layer) of the laser device 10C is arranged with respect to the active layer of the semiconductor laser 1 is arranged in the z-axis negative direction side.

Also in the configuration of the laser device 10C of Fig. 18, the solid-state laser medium 2 is shared the optical resonator res1 and the optical resonator res2. Therefore, the gain density in the solid-state laser medium 2 can be increased. Also in the laser device 10C, the solid-state laser medium 2 and the Q switch 3 combines the functions of a pair of reflectors in the optical resonator res2. Therefore, it is easy to shorten the resonator length of the optical resonator res2 and it is possible to reduce the size of the laser device. Furthermore, in the laser device 10C, since the gain density of the solid-state laser medium 2 is increased, it is possible to increase the repetition frequency of the pulse laser light 5.

In addition, in the laser device 10C, the reflective layer R2' having a relaxed requirement regarding to a performance may be used instead of the reflective layer R2. As described above, since the reflective layer R2' and the reflective layer R1 can be realized by the common DBR, the reflective layer is easily designed. Thus, by employing the laser device 10C of Fig. 18, it is possible to suppress the cost of designing and manufacturing the laser device.

The laser device according to the present disclosure may include the excitation light source, the laser medium, and the saturable absorber. The excitation light source has the first reflective layer with respect to the first wavelength and the second reflective layer with respect to the second wavelength, which are coplanar. The laser medium has the third reflective layer with respect to the first wavelength on the second surface opposite the excitation light source. The saturable absorber has the fourth reflective layer with respect to the second wavelength on the third surface opposite the laser medium. The third reflective layer may transmit a part of the first wavelength. The fourth reflective layer may transmit a part of the second wavelength. The first wavelength may be a wavelength of the excitation light generated by the excitation light source. The second wavelength may be the oscillation wavelength of the laser medium. At least a part of the fourth surface facing to the laser medium of the excitation light source may be the exit surface of the excitation light.

The semiconductor laser 1 described above is an example of the excitation light source. The solid-state laser medium 2 is an example of the laser medium. The Q switch 3 is an example of the saturable absorber. The reflective layer R1 is an example of the first reflective layer. The reflective layer R2 is an example of the second reflective layer. The surface 202 is an example of the second surface. The reflective layer R3 is an example of the third reflective layer. The reflective layer R4 is an example of the fourth reflective layer.

Furthermore, the excitation light source may have the fifth reflective layer with respect to the first wavelength on the fourth surface facing to the laser medium. The fifth reflective layer may transmit a part of the first wavelength. The excitation light source may be the surface emitting semiconductor laser including the p-type semiconductor multilayer reflective layer, the n-type semiconductor multilayer reflective layer, the active layer including the quantum well, the positive electrode in contact with the p-type semiconductor multilayer reflective layer, and the negative electrode in contact with the n-type semiconductor multilayer reflective layer. The transmittance of the fifth reflective layer with respect to the first wavelength may be higher than that of the first reflective layer. Furthermore, the reflectance of the first reflective layer with respect to the first wavelength may be higher than that of the fifth reflective layer.

The reflective layer R5 is an example of the fifth reflective layer. The reflective layer R5 (p-DBR) is an example of the p-type semiconductor multilayer reflective layer.

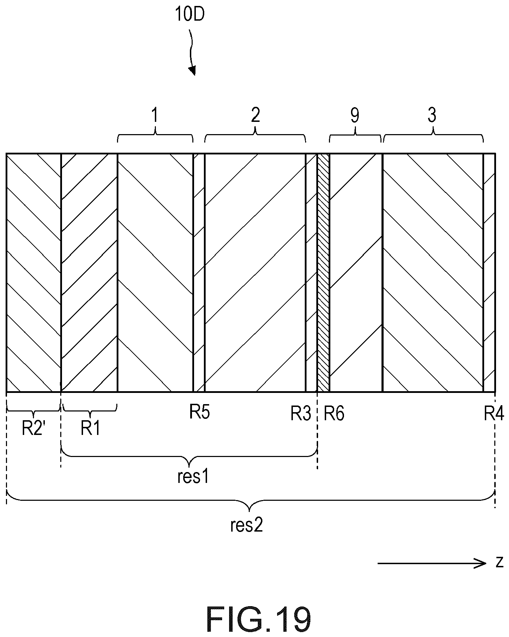

Fig. 19 is a cross-sectional diagram showing an example of a laser device according to Modification 6. A laser device 10D of Fig. 19 is obtained by adding a wavelength converting material 9 and the reflective layer R6 to the laser device 10C of Fig. 18. The wavelength conversion material 9 is arranged between the solid-state laser medium 2 and the Q switch 3. Note that the arrangement of the wavelength conversion material may be different from this. For example, the wavelength conversion material may be arranged on the positive z-axis direction side from the Q switch 3. The wavelength conversion material 9 is, for example, nonlinear optical crystal such as LiNbO₃, BBO, LBO, CLBO, BiBO, KTP, and SLT. As the wavelength conversion material 9, a phase matching material similar to these may be used. Note that the type of the wavelength conversion material is not limited. The oscillation light of the optical resonator res2 is converted into laser light having a wavelength λ_{c} by the wavelength converting material 9.

Furthermore, the reflective layer R6 is formed on the surface between the solid-state laser medium 2 and the wavelength conversion material 9. The reflective layer R6 is a reflective layer with respect to the laser light having a wavelength λ_{c}. The laser light reflected by the reflective layer R6 is emitted in the z-axis positive direction from the laser device 10D. Incidentally, other components are the same as the semiconductor laser device 10C of Fig. 18.

The laser device according to the present disclosure may further include a wavelength conversion material arranged between the second reflective layer and the fourth reflective layer. Furthermore, it may further include a sixth reflective layer with respect to the wavelength after conversion by the wavelength conversion material on the fifth surface of the wavelength conversion material facing to the excitation light source.

Here, the reflective layer R2 is an example of the second reflective layer. The reflective layer R4 is an example of the fourth reflective layer. The semiconductor laser 1 is an example of the excitation light source. The surface of the wavelength conversion material 9 of Fig. 19 in the z-axis negative direction side is an example of the fifth surface. The reflective layer R6 is an example of the sixth reflective layer.

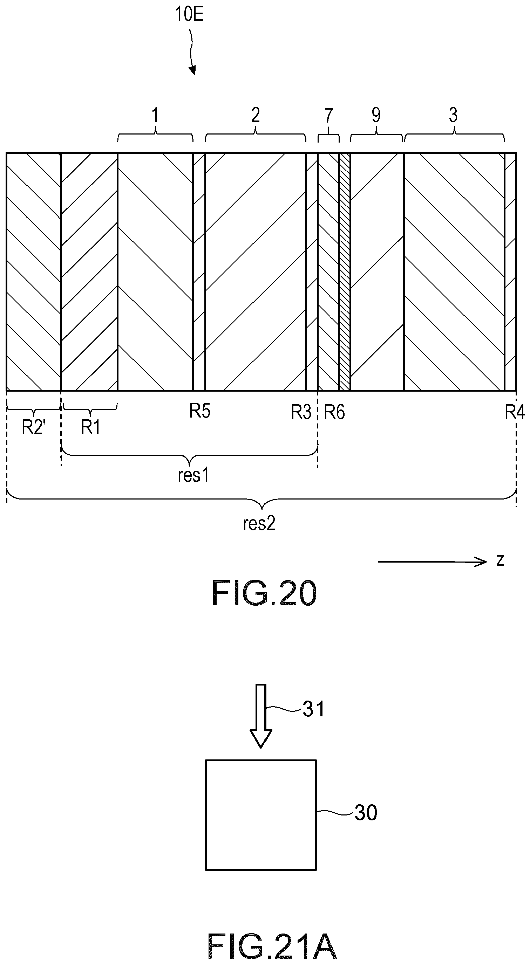

Fig. 20 is a cross-sectional diagram showing an example of a laser device according to Modification 7. A laser device 10E of Fig. 20 is obtained by adding the radiator plate 7 to the laser device 10D of Fig. 19. The radiator plate 7 is arranged between the reflective layer R3 and the reflective layer R6. As the radiator plate 7, for example, undoped YAG crystal, quartz, or sapphire can be used. Note that the material of the radiator plate 7 is not limited. Incidentally, the arrangement of the radiator plate shown in Fig. 20 is only an example. Therefore, the radiator plate may be arranged on a different surface from this. The number of the radiator plate may be different from that in the example of Fig. 20. Thus, the laser device according to the present disclosure may further include one or more radiator plates.

The laser device and the laser apparatus according to the present disclosure each employs a laminated structure in which the optical axis of the excitation light and the optical axis of the laser light are coaxial. In the laser device and the laser apparatus according to the present disclosure, there is no need to perform complex positional and angular alignment, and the structure is simplified. Therefore, it is easy to miniaturize the laser device and the laser apparatus. Furthermore, by laminating or bonding a plurality of materials on the same semiconductor substrate, it is possible to simultaneously form a plurality of laser devices according to the present disclosure. Since it is sufficient to perform dicing in a later step and to separate the respective laser devices, it is possible to mass-produce high-performance laser devices at a low cost.

Furthermore, in the laser device according to the present disclosure, the repetition frequency can be adjusted depending on the type of solid-state laser medium. In particular, in the laser device according to the disclosure, since the gain density is high, it is possible to increase the repetition frequency of the pulse laser light. Furthermore, in the laser device according to the present disclosure, it is possible to change the resonator length simply by adjusting thicknesses of the solid-state laser medium, the Q switch (saturable absorber), the wavelength conversion material (nonlinear optical crystal). That is, it is possible to change the pulse time width of the laser light by the thicknesses of the materials, it is possible to easily adjust the characteristics of the laser. In particular, by shortening the pulse time width of the laser light, it is possible to increase the machining accuracy in the microfabrication field. Furthermore, by arranging the laser device according to the present disclosure in a one-dimensional array or two-dimensional array, it is possible to obtain a laser apparatus having both high machining accuracy and high output energy. The laser device and the laser apparatus according to the present disclosure can also be applied to other fields such as a high efficiency wavelength conversion technology, a medical device, and ranging.

### (Second Embodiment)

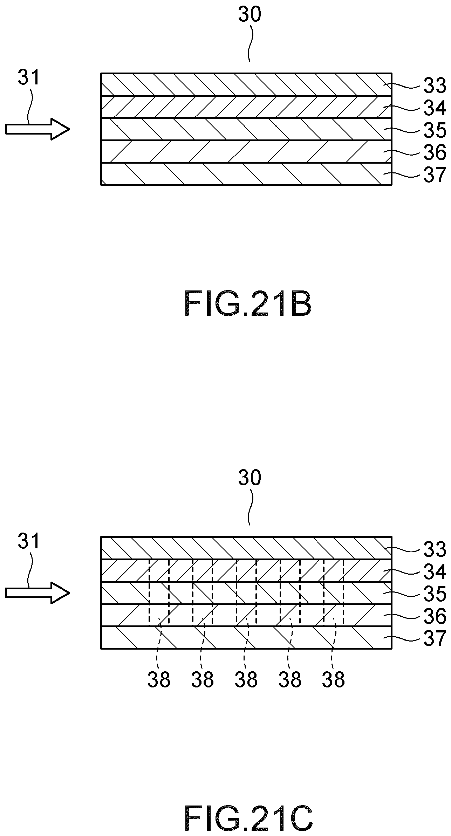

The laser apparatus according to a second embodiment includes a laser amplifying device 30. Figs. 21A and 21B are a top diagram and a cross-sectional diagram of the laser amplifying device 30 according to the present embodiment. The laser amplifying device 30 according to the present embodiment amplifies laser light 31 through an amplifying medium 35 that is the laser medium. The laser amplifying device 30 is obtained by laminating a high reflective coat layer 33, a heat sink 34, a laser medium (amplifying medium) 35, a heat sink 36, and a surface emitting laser device 37.

The surface emitting laser device 37 is a part of the surface emitting semiconductor laser (VCSEL), and is also referred to as a half VCSEL. The surface emitting laser device 37 has one of distributed Bragg reflectors (DBRs) in the VCSEL, and an active layer. The high reflective coat layer 33 forms a pump module.

The amplifying medium 35, which is the laser medium, is a solid medium formed as a single crystal structure that can be partially doped. The amplifying medium 35 has a rectangular cross-section and can be referred to as a single crystal slab. The amplifying medium 35 is not necessarily formed of single crystal, and may be glass or ceramic. In addition, the slab may be formed in a sandwich structure in which the doped medium is between two undoped media.

The laser light 31 that is amplified light is generally generated from a laser light source which is considered to be a main oscillator. A low-power laser main oscillator generates the pulse laser light, and the pulse laser light enters the laser amplifying device 30. The pulse laser light from the laser main oscillator stimulates radiation in the amplifying medium 35 to generate a higher output energy pulse.

The amplifying medium 35 needs to be pumped from a secondary light source to act as the laser amplifying device. A principle for this is described below. The surface emitting laser device 37 has a p-side highly reflective film and an active layer in a VCSEL structure. A partial reflective film may be on an n-side. By injecting a current from outside into the laser device 37, the spontaneous emission occurs first in the active layer, and a part thereof is absorbed by the amplifying medium 35, but is reflected by a high reflective coat 33, and returns to the laser device 37, thereby inducing the stimulated emission. Thus, in principle, by arranging the amplifying medium 35 which is excited by the oscillating light inside the resonator of the VCSEL, to thereby pumping the amplifying medium 35 simultaneously with the oscillation of the VCSEL. By two-dimensionally arranging the laser devices 37 in an array, excitation regions 38 of the amplifying medium 35 can be expanded in a planar direction as shown in Fig. 21C. Although a region between the respective excitation regions 38 being not excited by the oscillation light is generated, by appropriately adjusting an interval of the laser devices 37 and the opening of the light emitting portion so that the oscillation light is spread by the diffraction effect, to thereby exciting.

Summarizing the above, the laser amplifying device 30 according to the second embodiment has the surface emitting laser device 37 which acts as the excitation light source. The surface emitting laser device 37 includes the first reflective layer with respect to the first wavelength. Furthermore, the laser amplifying device 30 according to the second embodiment includes the amplifying medium 35. The amplifying medium 35 includes the second reflective layer with respect to the second wavelength on the first surface facing to the surface emitting laser device 37 that is the excitation light source, and the third reflective layer with respect to the first wavelength and the second wavelength on the second surface opposite to the first surface. The surface emitting laser device 37 that is the excitation light source has the third surface facing to the amplifying medium 35. The first wavelength is the wavelength of the excitation light generated by the excitation light source, and at least a part of the third surface is the exit surface of the excitation light. The excitation light source may have the fourth reflective layer with respect to the first wavelength on the third surface, and the fourth reflective layer may transmit a part of the first wavelength. The surface emitting laser device 37 that is the excitation light source may include the p-type semiconductor multilayer reflective layer, the n-type semiconductor multilayer reflective layer, the active layer including the quantum well, the positive electrode in contact with the p-type semiconductor multilayer reflective layer, and the negative electrode in contact with the n-type semiconductor multilayer reflective layer. The excitation light source may have the active layer of the surface emitting semiconductor laser 37 having a plurality of light emitting points arranged on one surface of the excitation light source, a first multilayer film reflecting mirror, and a second multilayer film reflecting mirror arranged through the amplifying medium. By current injection from outside to the active layer of the surface emitting semiconductor laser 37, the laser oscillation occurs at the wavelength determined by the band gap of the active layer between the first and second multilayer reflecting mirrors, the excitation light generated by the laser oscillation is excited by the amplifying medium, and the laser light passing through the amplifying medium in a direction perpendicular to the optical axis of the excitation light is uniformly amplified. The pulse laser light is combined from outside to the amplifying medium 35, and its output is amplified.

An advantage of the laser amplifying device 30 in accordance with the second embodiment is that the amplifying medium 35 such as MOPA crystal can be pumped by a single optical assembly.

A further advantage of the laser amplifying device 30 in accordance with the second embodiment is that a footprint of the amplifying medium 35 is not limited by an absorption length determined by the wavelength of a pumping secondary light source, thus providing an apparatus for amplifying laser light capable of output scaling. A further advantage of the laser amplifying device 30 in accordance with the second embodiment is that it can provide the laser amplifying device 30 including an optically excited single crystal slab active region, which is pumped in a simpler and more compact arrangement than the prior art.

The amplification medium 35 includes, for example, YAG (yttrium aluminum garnet) crystal doped with Yb (yttrium). In this case, the oscillation wavelength of the solid-state laser medium 2 is 1030 nm. For example, as the lasing medium of the amplifying medium 35, at least one material of Nd:YAG, Nd:YVO4, Nd:YLF, Nd:glass, Yb:YAG, Yb:YLF, Yb:FAP, Yb:SFAP, Yb:YVO, Yb:glass, Yb:KYW, Yb:BCBF, Yb:YCOB, Yb:GdCOB, and YB:YAB can be used. The amplifying medium 35 may be the laser medium of the four-level system or the laser medium of the three-level system. Note that the type of the laser medium used in the amplifying medium 35 is not limited.

The material used in the Figs. 21A to 21C may be a structure with no gaps between layers. On the other hand, it does not prevent to employ a structure having gaps between components. There may be a heat sink material between the solid-state laser media 35. As the heat sink material, sapphire, undoped YAG, CVD diamond, quartz, or the like can be used.

The solid-state laser medium 35 and the heat sink material 3 may be bonded. Here, as examples of the bonding process includes normal temperature bonding, atomic diffusion bonding, and plasma bonding. Note that other types of processes may be used. In addition, the components may be mechanically fixed to each other.

The present technology may have the following structures.
(1) A laser device, including:
   an excitation light source having a first reflective layer with respect to a first wavelength;
   a laser medium having a second reflective layer with respect to a second wavelength on a first surface facing to the excitation light source and a third reflective layer with respect to the first wavelength on a second surface opposite to the first surface; and
   a saturable absorber having a fourth reflective layer with respect to the second wavelength on a third surface opposite to the laser medium.
(2) The laser device according to (1), in which
   the first wavelength is a wavelength of the excitation light generated by the excitation light source, and
   at least a part of a fourth surface facing to the laser medium of the excitation light source is an exit surface of the excitation light.
(3) The laser device according to (2), in which
   the excitation light source includes a fifth reflective layer with respect to the first wavelength on the fourth surface, and the fifth reflective layer transmits a part of the first wavelength.
(4) The laser device according to (3), in which
   the excitation light source is a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer.
(5) The laser device according to (3) or (4), in which
   transmittance of the fifth reflective layer with respect to the first wavelength is higher than that of the first reflective layer.
(6) The laser device according to any one of (3) to (5), in which
   reflectance of the first reflective layer with respect to the first wavelength is higher than that of the fifth reflective layer.
(7) The laser device according to any one of (1) to (6), in which
   the third reflective layer transmits a part of the first wavelength.
(8) The laser device according to any one of (1) to (7), in which
   the fourth reflective layer transmits a part of the second wavelength.
(9) The laser device according to any one of (1) to (8), in which
   the second wavelength is an oscillation wavelength of the laser medium.
(10) The laser device according to any one of (1) to (9), in which
   a first anti-reflective film with respect to the first wavelength is provided between the excitation light source and the laser medium.
(11) The laser device according to any one of (1) to (10), in which
   a second anti-reflective film with respect to the second wavelength is provided between the laser medium and the saturable absorber.
(12) The laser device according to any one of (1) to (11), further including:
   one or more radiator plates arranged on at least one of between the excitation light source and the laser medium, between the laser medium and the saturable absorber, or on the third surface of the saturable absorber.
(13) The laser device according to any one of (1) to (12), further including:
   a wavelength conversion material arranged between the second reflective layer and the fourth reflective layer.
(14) The laser device according to (13), in which
   the wavelength conversion material includes a sixth reflective layer with respect to a wavelength after conversion by the wavelength conversion material on the fifth surface facing to the excitation light source.
(15) The laser device according to any one of (1) to (14), in which
   the laser medium is a laser medium of a four-level system or a three-level system.
(16) A laser device, including:
   an excitation light source having a first reflective layer with respect to a first wavelength and a second reflective layer with respect to a second wavelength, which are coplanar;
   a laser medium having a third reflective layer with respect to the first wavelength on a second surface opposite to the excitation light source; and
   a saturable absorber having a fourth reflective layer with respect to the second wavelength on a third surface opposite to the laser medium.
(17) A method of manufacturing a laser device, including:
   forming a laminated structure in which a plurality of materials are stacked on a semiconductor substrate and then dicing the laminated structure to manufacture a plurality of laser devices, each laser device including
   an excitation light source having a first reflective layer with respect to a first wavelength and a second reflective layer with respect to a second wavelength,
   a laser medium having a second reflective layer with respect to a second wavelength on a first surface facing to the excitation light source and a third reflective layer with respect to the first wavelength on a second surface opposite to the first surface, and
   a saturable absorber having a fourth reflective layer with respect to the second wavelength on a third surface opposite to the laser medium.
(18) A laser apparatus including a plurality of laser devices according to any one of (1) to (16).
(19) The laser apparatus according to (18), in which
   the plurality of laser devices are arranged in a one-dimensional array or a two-dimensional array.
(20) The laser apparatus according to (19), further including:
   a drive circuit configured to supply an electrical signal for driving to at least one of the laser devices.
(21) A laser amplifying device, including:
   an excitation light source having a first reflective layer with respect to a first wavelength; and
   an amplifying medium having a second reflective layer with respect to a second wavelength on a first surface facing to the excitation light source and having a third reflective layer with respect to the first wavelength and the second wavelength on a second surface opposite to the first surface.
(22) The laser amplifying device according to (21), in which
   the excitation light source includes a third surface facing to the amplifying medium,
   the first wavelength is a wavelength of the excitation light generated by the excitation light source, and
   at least a part of the third surface is an emission surface of the excitation light.
(23) The laser amplifying device according to (22), in which
   the excitation light source includes a fourth reflective layer with respect to the first wavelength on the third surface, and
   the fourth reflective layer transmits a part of the first wavelength.
(24) The laser amplifying device according to (21), in which
   the excitation light source is a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer.
(25) The laser amplifying device according to (21), in which
   the excitation light source has an active layer of a surface emitting semiconductor laser having a plurality of light emitting points arranged on one surface of the excitation light source, a first multilayer film reflecting mirror, and a second multilayer film reflecting mirror installed through the amplifying medium.
(26) The laser amplifying device according to (25), in which
   by current injection from outside to the active layer, laser oscillation occurs at a wavelength determined by a band gap of the active layer between first and second multilayer reflecting mirrors, the excitation light generated by the laser oscillation is pumped by the amplifying medium, and laser light passing through the amplifying medium from the excitation light source is uniformly amplified.
(27) The laser amplifying device according to (21), in which
   pulse laser light is coupled to the amplifying medium from outside to amplify the output.

Aspects of the present disclosure are not limited to the individual embodiments described above, but also include various modifications that may be conceived by those skilled in the art, and the effects of the present disclosure are not limited to the contents described above. In other words, various additions, modifications, and partial deletions may be made without departing from the conceptual spirit and the gist of the present disclosure which is derived from the content defined in the claims and the equivalents thereof.

### Reference Signs List

res1, res2 optical resonator
1 semiconductor laser (surface emitting semiconductor laser)
2 solid-state laser medium
3 Q switch (saturable absorber)
4 excitation light
5 pulse laser light
5A oscillation light
5B laser light
10 laser device
11, 15 support portion
12, 13 drive circuit
14 control circuit
20, 21, 22 laser apparatus
401 semiconductor substrate (n-type GaAs substrate)
402 contact layer (n-type semiconductor)
403 reflective layer (n-DBR)
404, 406 cladding layer
405 active layer
407 oxide layer
408 reflective layer (n-DBR)
409 contact layer (p-type semiconductor)
501 constriction structure
502 negative electrode (n-electrode)
503 positive electrode (p-electrode)
504 submount
505 electrode
508, 511 insulation

## Claims

1. A laser device, comprising:
an excitation light source having a first reflective layer with respect to a first wavelength;
a laser medium having a second reflective layer with respect to a second wavelength on a first surface facing to the excitation light source and a third reflective layer with respect to the first wavelength on a second surface opposite to the first surface; and
a saturable absorber having a fourth reflective layer with respect to the second wavelength on a third surface opposite to the laser medium.

2. The laser device according to claim 1, wherein
the first wavelength is a wavelength of the excitation light generated by the excitation light source, and
at least a part of a fourth surface facing to the laser medium of the excitation light source is an exit surface of the excitation light.

3. The laser device according to claim 2, wherein
the excitation light source includes a fifth reflective layer with respect to the first wavelength on the fourth surface, and the fifth reflective layer transmits a part of the first wavelength.

4. The laser device according to claim 3, wherein
the excitation light source is a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer.

5. The laser device according to claim 3, wherein
transmittance of the fifth reflective layer with respect to the first wavelength is higher than that of the first reflective layer.

6. The laser device according to claim 3, wherein
reflectance of the first reflective layer with respect to the first wavelength is higher than that of the fifth reflective layer.

7. The laser device according to claim 1, wherein
the third reflective layer transmits a part of the first wavelength.

8. The laser device according to claim 1, wherein
the fourth reflective layer transmits a part of the second wavelength.

9. The laser device according to claim 1, wherein
the second wavelength is an oscillation wavelength of the laser medium.

10. The laser device according to claim 1, wherein
a first anti-reflective film with respect to the first wavelength is provided between the excitation light source and the laser medium.

11. The laser device according to claim 1, wherein
a second anti-reflective film with respect to the second wavelength is provided between the laser medium and the saturable absorber.

12. The laser device according to claim 1, further comprising:
one or more radiator plates arranged on at least one of between the excitation light source and the laser medium, between the laser medium and the saturable absorber, or on the third surface of the saturable absorber.

13. The laser device according to claim 1, further comprising:
a wavelength conversion material arranged between the second reflective layer and the fourth reflective layer.

14. The laser device according to claim 13, wherein
the wavelength conversion material includes a sixth reflective layer with respect to a wavelength after conversion by the wavelength conversion material on the fifth surface facing to the excitation light source.

15. The laser device according to claim 1, wherein
the laser medium is a laser medium of a four-level system or a three-level system.

16. A laser device, comprising:
an excitation light source having a first reflective layer with respect to a first wavelength and a second reflective layer with respect to a second wavelength, which are coplanar;
a laser medium having a third reflective layer with respect to the first wavelength on a second surface opposite to the excitation light source; and
a saturable absorber having a fourth reflective layer with respect to the second wavelength on a third surface opposite to the laser medium.

17. A method of manufacturing a laser device, comprising:
forming a laminated structure in which a plurality of materials are stacked on a semiconductor substrate and then dicing the laminated structure to manufacture a plurality of laser devices, each laser device including
an excitation light source having a first reflective layer with respect to a first wavelength and a second reflective layer with respect to a second wavelength,
a laser medium having a second reflective layer with respect to a second wavelength on a first surface facing to the excitation light source and a third reflective layer with respect to the first wavelength on a second surface opposite to the first surface, and
a saturable absorber having a fourth reflective layer with respect to the second wavelength on a third surface opposite to the laser medium.

18. A laser apparatus comprising a plurality of laser devices according to claim 1.

19. The laser apparatus according to claim 18, wherein
the plurality of laser devices are arranged in a one-dimensional array or a two-dimensional array.

20. The laser apparatus according to claim 19, further comprising:
a drive circuit configured to supply an electrical signal for driving to at least one of the laser devices.

21. A laser amplifying device, comprising:
an excitation light source having a first reflective layer with respect to a first wavelength; and
an amplifying medium having a second reflective layer with respect to a second wavelength on a first surface facing to the excitation light source and having a third reflective layer with respect to the first wavelength and the second wavelength on a second surface opposite to the first surface.

22. The laser amplifying device according to claim 21, where
the excitation light source includes a third surface facing to the amplifying medium,
the first wavelength is a wavelength of the excitation light generated by the excitation light source, and
at least a part of the third surface is an emission surface of the excitation light.

23. The laser amplifying device according to claim 22, wherein
the excitation light source includes a fourth reflective layer with respect to the first wavelength on the third surface, and
the fourth reflective layer transmits a part of the first wavelength.

24. The laser amplifying device according to claim 21, wherein
the excitation light source is a surface emitting semiconductor laser including a p-type semiconductor multilayer reflective layer, an n-type semiconductor multilayer reflective layer, an active layer including a quantum well, a positive electrode in contact with the p-type semiconductor multilayer reflective layer, and a negative electrode in contact with the n-type semiconductor multilayer reflective layer.

25. The laser amplifying device according to claim 21, wherein
the excitation light source has an active layer of a surface emitting semiconductor laser having a plurality of light emitting points arranged on one surface of the excitation light source, a first multilayer film reflecting mirror, and a second multilayer film reflecting mirror installed through the amplifying medium.

26. The laser amplifying device according to claim 25, wherein
by current injection from outside to the active layer, laser oscillation occurs at a wavelength determined by a band gap of the active layer between first and second multilayer reflecting mirrors, the excitation light generated by the laser oscillation is pumped by the amplifying medium, and laser light passing through the amplifying medium from the excitation light source is uniformly amplified.

27. The laser amplifying device according to claim 21, wherein
pulse laser light is coupled to the amplifying medium from outside to amplify the output.
